# EUROPEAN PATENT APPLICATION

(11) **EP 4 398 036 A1**
(43) Date of publication of application: **10.07.2024**
(21) Application number: 23219328.4
(22) Date of filing: 21.12.2023
(51) Int. Cl.: G03F 7/09, H01L 21/02, H01L 21/027, H01L 21/033, G03F 7/075

(54) **COMPOUND FOR FORMING METAL-CONTAINING FILM, COMPOSITION FOR FORMING METAL-CONTAINING FILM, AND PATTERNING PROCESS**

(30) Priority: 06.01.2023 JP 2023000801
(71) Applicant: SHIN-ETSU CHEMICAL CO., LTD., Tokyo 1000005 (JP)
(72) Inventor: KOBAYASHI, Naoki, Niigata (JP); NAGAMACHI, Nobuhiro, Niigata, Niigata (JP); KORI, Daisuke, Niigata (JP)
(74) Representative: Sonnenhauser, Thomas Martin

(57) **Abstract**

The present invention is a compound for forming a metal-containing film to be contained in a composition for forming a metal-containing film, where the compound is a metal compound including at least one kind of metal atom selected from the group consisting of Ti, Zr, and Hf and a ligand coordinated to the metal atom, and the ligand includes a crosslinking group represented by one of the following general formulae (W-1). This provides: a compound for forming a metal-containing film having better dry etching resistance than conventional resist underlayer film materials and also having high filling and planarizing properties; a composition for forming a metal-containing film containing the compound; and a patterning process in which the composition is used.

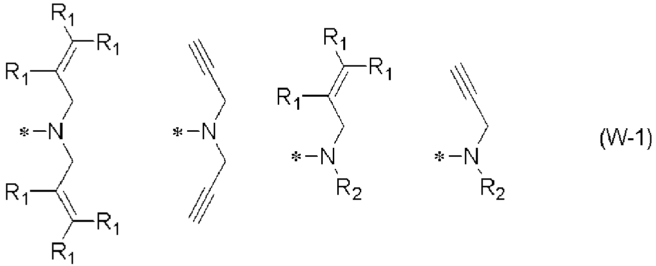

## Description

### TECHNICAL FIELD

The present invention relates to: a compound for forming a metal-containing film; a composition for forming a metal-containing film; and a patterning process using the composition.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist underlayer film having a different etching selectivity from a photoresist film (i.e., a resist upper layer film) is placed between the resist upper layer film and a substrate to be processed; a pattern is formed in the resist upper layer film; the pattern is transferred to the resist underlayer film by dry etching while using the resist upper layer film pattern as a dry etching mask; and the pattern is further transferred to the substrate to be processed by dry etching while using the resist underlayer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type resist underlayer film composition excellent in filling and planarizing properties, for example, the composition disclosed in Patent Document 2 has been reported. However, in view of application of this composition in the advanced generation, there is a concern about dry etching resistance. The application limit of the previously-known coating-type resist underlayer film composition is thus approaching.

To solve the problems, there is consideration of development of the use of a material containing a metal element for a resist underlayer film. Patent Document 3 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 3, a metal compound generally has large thermal shrinkage during baking and induces remarkable degradation of filling after baking at a high temperature. Therefore, there is a concern that such a compound is insufficient as a resist underlayer film material for which high planarizing and filling properties and heat resistance are required. Patent Documents 4 and 5 report that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases).

### CITATION LIST

### PATENT LITERATURE

Patent Document 1: JP2004-205685A
Patent Document 2: JP6714493B2
Patent Document 3: JP6189758B2
Patent Document 4: JP6786391B2
Patent Document 5: JP7050137B2

### SUMMARY OF INVENTION

### TECHNICAL PROBLEM

The present invention has been made in view of the above-described circumstances. An object of the present invention is to provide: a compound for forming a metal-containing film having better dry etching resistance than conventional resist underlayer film materials and also having high filling and planarizing properties; a composition for forming a metal-containing film containing the compound; and a patterning process in which the composition is used.

### SOLUTION TO PROBLEM

To achieve the object, the present invention provides a compound for forming a metal-containing film to be contained in a composition for forming a metal-containing film, wherein the compound is a metal compound comprising at least one kind of metal atom selected from the group consisting of Ti, Zr, and Hf and a ligand coordinated to the metal atom, and the ligand includes a crosslinking group represented by one of the following general formulae (W-1), 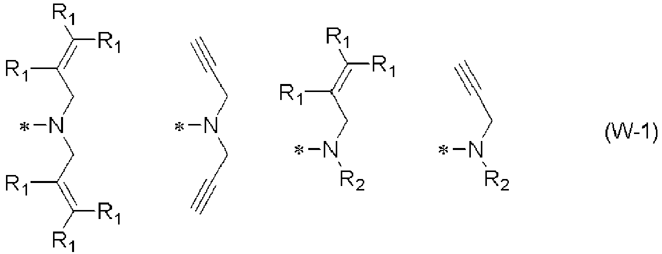 wherein R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.

Such a compound for forming a metal-containing film includes at least one crosslinking group represented by one of the formulae (W-1). Therefore, when the compound is contained in a composition for forming a metal-containing film, volume shrinkage during baking is small because the composition is excellent in thermosetting property, and unlike metal-containing compounds such as those reported in Patent Documents 4 and 5, the inventive compound can provide a resist material that has excellent planarizing and filling properties even after high-temperature baking and also has sufficient dry etching resistance.

In the present invention, the compound is preferably represented by the following general formula (A), 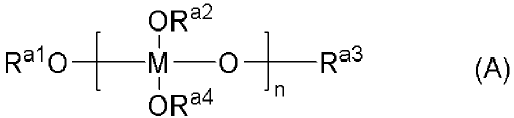 wherein M represents Ti, Zr, or Hf; R^{a1}, R^{a2}, R^{a3}, and R^{a4} each represent an organic group represented by the following general formula (1), a silicon-containing organic group represented by the following general formula (2), or an alkyl group having 1 to 10 carbon atoms, at least one of R^{a1}, R^{a2}, R^{a3}, and R^{a4} being an organic group represented by the following general formula (1) and at least one of R^{a1}, R^{a2}, R^{a3}, and R^{a4} being a silicon-containing organic group represented by the following general formula (2); and "n" represents 1 to 30, 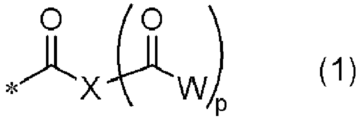 wherein X represents an organic group having 1 to 31 carbon atoms and having a valency of p+1; W represents any structure represented by one of the general formulae (W-1); "p" represents 1 to 4; and "*" represents an attachment point to an oxygen atom, 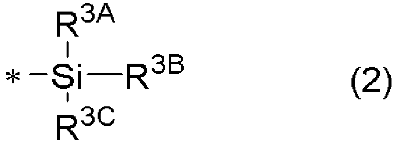 wherein R^{3A}, R^{3B}, and R^{3C} each represent any organic group selected from an organic group having 2 to 30 carbon atoms and having a crosslinking group of any structure represented by one of the following general formulae (c-1) to (c-3), a substituted or unsubstituted alkyl group having 1 to 20 carbon atoms, and an aryl group having 6 to 20 carbon atoms; and "*" represents an attachment point to an oxygen atom, 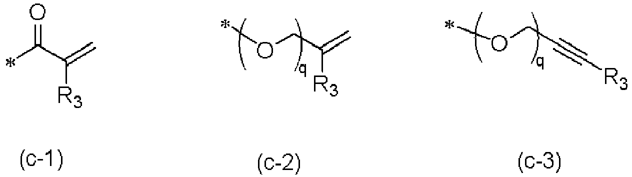 wherein R₃ represents a hydrogen atom or a monovalent organic group having 1 to 10 carbon atoms; "q" represents 0 or 1; and "*" represents an attachment point.

Such a compound for forming a metal-containing film includes at least one organic group represented by the general formula (1), and therefore, has excellent heat resistance, and also includes a crosslinking group on an end, and therefore, has excellent thermosetting property. Accordingly, when the compound is contained in a composition for forming a metal-containing film, it is possible to provide a resist material having excellent planarizing and filling properties even after baking at a high temperature. The compound also includes at least one silicon-containing organic group, and therefore, can provide a composition for forming a metal-containing film having excellent stability.

In the present invention, the X in the general formula (1) preferably represents a saturated hydrocarbon group having 1 to 20 carbon atoms or an unsaturated hydrocarbon group having 2 to 20 carbon atoms.

In the general formula (1), when X represents a saturated hydrocarbon group having 1 to 20 carbon atoms or an unsaturated hydrocarbon group having 2 to 20 carbon atoms, the thermosetting property of the compound for forming a metal-containing film can be improved. When this compound is contained in a composition for forming a metal-containing film, it is possible to provide a resist material that exhibits better planarizing and filling properties.

In the present invention, the X in the general formula (1) preferably represents one of the following general formulae (3), 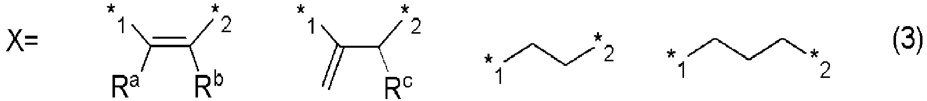 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.

When the X in the general formula (1) represents one of the general formulae (3), the thermosetting property of the compound for forming a metal-containing film can be further improved. When this compound is contained in a composition for forming a metal-containing film, it is possible to provide a resist material that exhibits better planarizing and filling properties.

In the present invention, the silicon-containing organic group preferably has a structure represented by one of the following general formulae (2A), 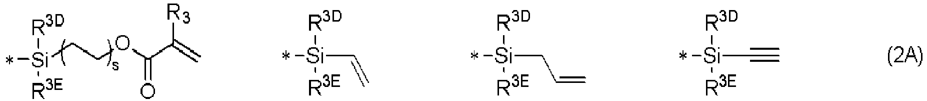 wherein R^{3D} and R^{3E} each represent an organic group selected from a substituted or unsubstituted alkyl group having 1 to 20 carbon atoms and an aryl group having 6 to 20 carbon atoms; R₃ is as defined above; "s" represents 1 to 10; and "*" represents an attachment point to an oxygen atom.

When the silicon-containing organic group has a structure represented by one of the general formulae (2A), the thermosetting property of the compound for forming a metal-containing film can be further improved. When this compound is contained in a composition for forming a metal-containing film, it is possible to provide a resist material that exhibits better planarizing and filling properties.

The present invention also provides a composition for forming a metal-containing film comprising: (A) the above-described compound for forming a metal-containing film; and (B) an organic solvent.

Such a composition for forming a metal-containing film contains a metal-containing compound excellent in heat resistance and thermal flowability, and therefore, can provide a resist material having better dry etching resistance than conventional resist underlayer film materials and also having higher filling and planarizing properties than conventional resist underlayer film materials.

In the present invention, the composition preferably further comprises one or more of (C) a crosslinking agent, (E) a surfactant, and (F) an acid generator.

When the composition for forming a metal-containing film contains one or more of the above additives, it is possible to obtain a resist material having better coating property, dry etching resistance, and filling and planarizing properties.

In the present invention, the organic solvent (B) preferably contains, as (B1) a high-boiling-point solvent, one or more kinds of organic solvent having a boiling point of 180°C or higher.

By imparting thermal flowability to the composition for forming a metal-containing film by adding a high-boiling-point solvent, the resist material is provided with both high filling property and high planarizing property.

In the present invention, the composition for forming a metal-containing film preferably further comprises (G) metal oxide nanoparticles having an average primary particle size of 100 nm or less.

In this event, the metal oxide nanoparticles (G) are preferably selected from the group consisting of zirconium oxide nanoparticles, hafnium oxide nanoparticles, titanium oxide nanoparticles, tin oxide nanoparticles, and tungsten oxide nanoparticles.

When such metal oxide nanoparticles are contained, the metal content in the composition can be increased easily, and the dry etching resistance of the resist material can be improved further.

In the present invention, the composition for forming a metal-containing film preferably further comprises (BP) a flowability accelerator having any organic group represented by the following general formulae (3') and an aromatic ring, 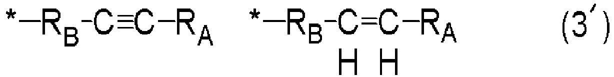 wherein "*" represents an attachment point to an oxygen atom; R_{B} represents a divalent organic group having 1 to 10 carbon atoms; and R_{A} represents a hydrogen atom or a monovalent organic group having 1 to 10 carbon atoms.

When heat resistance and thermal flowability are imparted to the composition for forming a metal-containing film by adding a flowability accelerator (BP), the resist material is provided with both even higher filling property and even higher planarizing property.

In this event, the flowability accelerator (BP) preferably has at least one constitutional unit represented by the following general formulae (BP-1), (BP-2), (BP-3), (BP-4), and (BP-5), 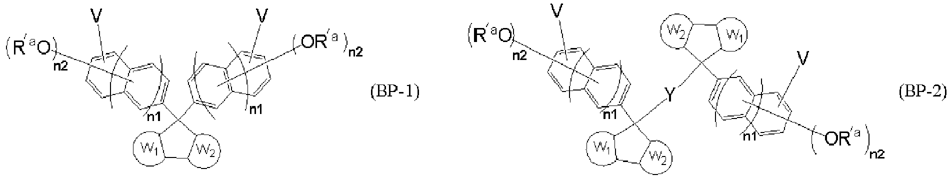 wherein W₁ and W₂ each independently represent a benzene ring or a naphthalene ring, part of hydrogen atoms in the benzene ring and the naphthalene ring optionally being substituted with a hydrocarbon group having 1 to 6 carbon atoms; each R'^{a} independently represents either group represented by the following formulae (4); Y represents any group represented by the following formulae (5); each "n₁" independently represents 0 or 1; each "n₂" independently represents 1 or 2; and each V independently represents a hydrogen atom or an attachment point, 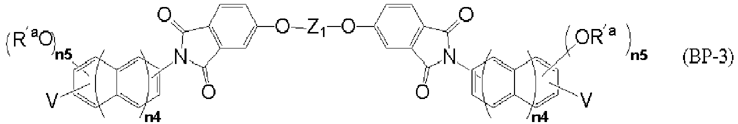 wherein Z₁ represents any group represented by the following general formulae (6); each R'^{a} independently represents either group represented by the following formulae (4); each "n₄" independently represents 0 or 1; each "n₅" independently represents 1 or 2; and each V independently represents a hydrogen atom or an attachment point, 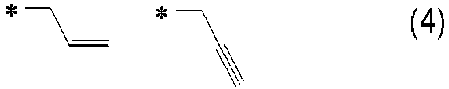 wherein "*" represents an attachment point to an oxygen atom, 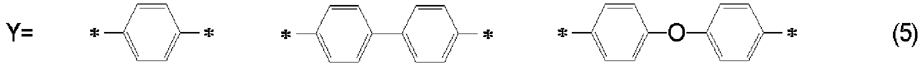 wherein "*" represents an attachment point, 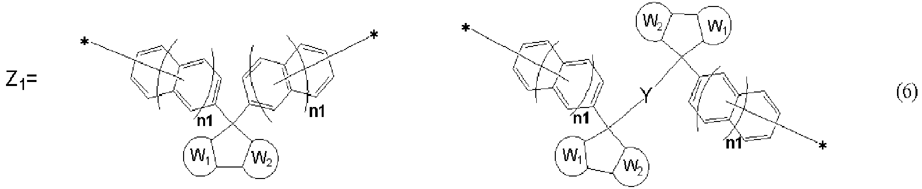 wherein W₁, W₂, Y, and "n₁" are as defined above; and "*" represents an attachment point, 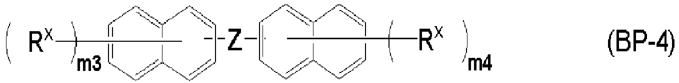 wherein "m₃" and "m₄" each independently represent 1 or 2; Z represents a single bond or any structure represented by the following general formulae (7); and each R^{x} independently represents any structure represented by the following general formulae (8), 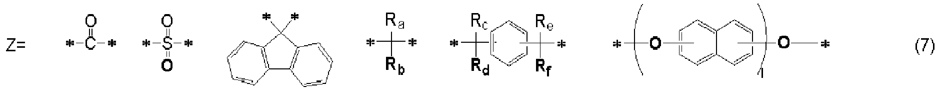 wherein "*" represents an attachment point; "l" represents an integer of 0 to 3; Rₐ to R_{f} each independently represent a hydrogen atom, an alkyl group having 1 to 10 carbon atoms and optionally having a substituent fluorine atom, a phenyl group, or a phenylethyl group, Rₐ and R_{b} optionally being bonded to each other to form a cyclic compound, 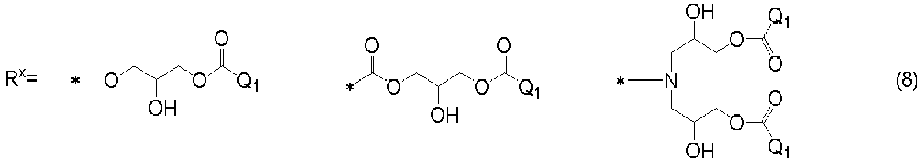 wherein "*" represents an attachment point to an aromatic ring; and Q₁ represents a linear saturated hydrocarbon group having 1 to 30 carbon atoms or a structure represented by the following general formula (9), 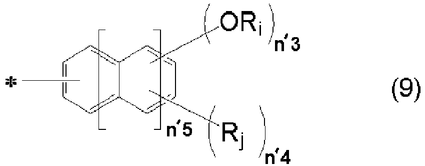 wherein "*" represents an attachment point to a carbonyl group; Rᵢ represents either group represented by the formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n'₃" and "n'₄" each represent a number of substituents on an aromatic ring, the number each representing an integer of 0 to 7, provided that n'₃+n'₄ is 0 or more and 7 or less; and "n'₅" represents 0 to 2, 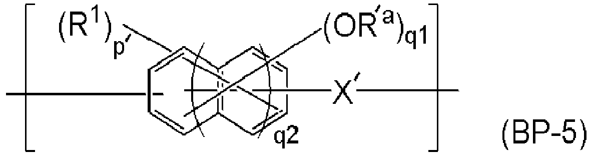 wherein R¹ represents a saturated monovalent organic group having 1 to 30 carbon atoms or an unsaturated monovalent organic group having 2 to 30 carbon atoms; X' represents a divalent organic group having 1 to 30 carbon atoms; R'^{a} represents either group represented by the formulae (4); "p'" represents an integer of 0 to 5 and "q₁" represents an integer of 1 to 6, provided that p'+q₁ is an integer of 1 or more and 6 or less; and "q₂" represents 0 or 1.

When the composition for forming a metal-containing film contains a flowability accelerator (BP) having at least one constitutional unit represented by the above (BP-1) to (BP-5), the composition provides a resist material having better filling and planarizing properties.

The present invention also provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the above-described composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with a high degree of accuracy.

The present invention also provides a patterning process for forming a pattern in a substrate to be processed, comprising the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with a high degree of accuracy.

In this event, the inorganic hard mask middle layer film is preferably formed by a CVD method or an ALD method.

When the inorganic hard mask is formed by a CVD method or an ALD method, a fine pattern can be formed on a body to be processed with higher accuracy.

The present invention also provides a patterning process for forming a pattern in a substrate to be processed, comprising the steps of:
(IV-1) applying the above-described composition for forming a metal-containing film onto a substrate to be processed, followed by heating to form a metal-containing film;
(IV-2) forming a resist underlayer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the resist underlayer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the resist underlayer film by dry etching while using the silicon-containing resist middle layer film or the inorganic hard mask middle layer film having the transferred pattern as a mask;
(IV-8) transferring the pattern to the metal-containing film by dry etching while using the resist underlayer film having the transferred pattern as a mask; and
(IV-9) processing the substrate to be processed while using the metal-containing film having the formed pattern as a mask to form the pattern in the substrate to be processed.

The patterning process by way of the multilayer resist process makes it possible to form fine patterns on the body to be processed with a high degree of accuracy.

The present invention also provides a tone-reversal patterning process for forming a pattern in a substrate to be processed, comprising the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with an even higher degree of accuracy.

### ADVANTAGEOUS EFFECTS OF INVENTION

As described above, the inventive compound for forming a metal-containing film contains a crosslinking group represented by one of the general formulae (W-1). Therefore, when the compound is contained in a composition for forming a metal-containing film, volume shrinkage during baking is small because the composition has an excellent thermosetting property. Thus, it is possible to provide a resist material having excellent planarizing and filling properties even after high-temperature baking.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type resist underlayer film materials, and therefore, a fine pattern can be formed on a body to be processed with even higher precision compared with a resist underlayer film.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the inventive tone-reversal patterning process.
FIG. 3 is an explanatory view of a method for evaluating the filling property.
FIG. 4 is an explanatory view of a method for evaluating the planarizing property.

### DESCRIPTION OF EMBODIMENTS

As stated above, there have been demands for the development of: a composition for forming a metal-containing film, excellent in filling property and planarization property, used for forming a resist underlayer film that makes it possible to transfer a resist pattern to a substrate to be processed with higher precision in a fine patterning process according to a multilayer resist method; a compound for forming a metal-containing film useful for the composition; and a patterning process using the composition.

The present inventors have focused on metal materials that exhibit better etching resistance than conventional resist underlayer film materials, and studied earnestly. On the other hand, conventional metal compounds for forming a resist underlayer film have poor heat resistance, and undergo rapid volume shrinkage during baking. Therefore, it is difficult to fill and planarize the steps of a substrate to be processed after high-temperature baking. The present inventors have considered that when an organic group excellent in heat resistance is contained, rapid volume shrinkage at the time of baking can be reduced and thermal flowability can be improved, so that steps of a substrate to be processed can be filled without voids being generated even after baking at a high temperature. The present inventors have also assumed that a compound for forming a metal-containing film having a structure that contains a crosslinking group at an end has excellent thermosetting property during baking, and therefore, has better heat resistance.

Meanwhile, it can be considered that when an organic ligand having a crosslinking group and having excellent heat resistance is introduced to a metal compound, the filling property is improved, but that there is a possibility that the greater amount of the organic component in the film has an adverse effect on etching resistance. The present inventors have assumed that it is possible to achieve a compound for forming a metal-containing film that has both high etching resistance and high filling property if it is possible to design an organic ligand including an organic component within a range in which etching resistance is not degraded and also including a crosslinking group having better thermosetting property.

The present inventors have studied earnestly further, and found out that a compound for forming a metal-containing film including a crosslinking group represented by one of the general formulae (W-1) can reduce sudden volume shrinkage during baking since the compound has excellent thermosetting property and can realize high filling and planarizing properties since the compound also has favorable thermal flowability. Thus, the present invention has been completed.

That is, the present invention is a compound for forming a metal-containing film to be contained in a composition for forming a metal-containing film, wherein the compound is a metal compound comprising at least one kind of metal atom selected from the group consisting of Ti, Zr, and Hf and a ligand coordinated to the metal atom, and the ligand includes a crosslinking group represented by one of the following general formulae (W-1), 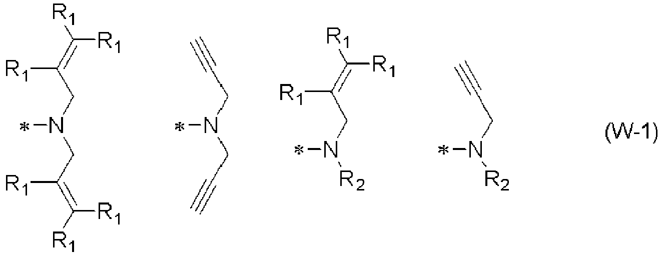 wherein R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.

Hereinafter, the present invention will be described in detail, but the present invention is not limited thereto.

### <Compound for Forming Metal-Containing Film>

The inventive compound for forming a metal-containing film is a compound for forming a metal-containing film to be contained in a composition for forming a metal-containing film. The compound is a metal compound including at least one kind of metal atom selected from the group consisting of Ti, Zr, and Hf and a ligand coordinated to the metal atom, and the ligand includes a crosslinking group represented by one of the following general formulae (W-1).

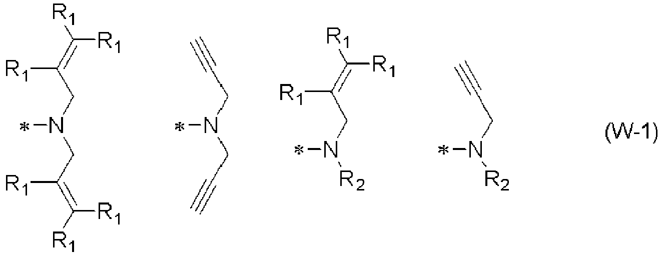

In the general formulae (W-1), R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.

In the general formulae (W-1), the R₁'s each represent a hydrogen atom or a methyl group, and the R₁'s are identical to or different from one another in the same formula. R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms. From the viewpoints of thermosetting property and etching resistance, both R₁ and R₂ are preferably a hydrogen atom.

Out of the structures of the general formulae (W-1), examples of preferable structures include the following structures, but are not limited thereto. From the viewpoint of thermosetting property, the structures of the following general formulae (W-a) and (W-b) are particularly preferable.

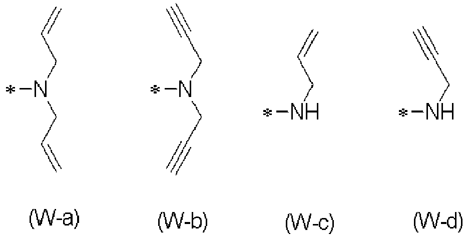

The structures of the general formulae (W-a) and (W-b) have more crosslinking groups, and therefore, a compound for forming a metal-containing film having better thermosetting property can be achieved, and when the compound is contained in a composition for forming a metal-containing film, volume shrinkage during high-temperature baking can be reduced. Thus, a resist material having excellent filling and planarizing properties can be provided.

The inventive compound for forming a metal-containing film is preferably represented by the following general formula (A).

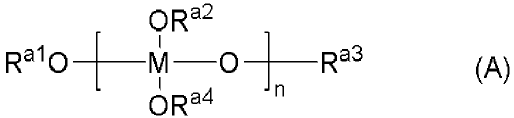

In the general formula (A), M represents Ti, Zr, or Hf; R^{a1}, R^{a2}, R^{a3}, and R^{a4} each represent an organic group represented by the following general formula (1), a silicon-containing organic group represented by the following general formula (2), or an alkyl group having 1 to 10 carbon atoms, at least one of R^{a1}, R^{a2}, R^{a3}, and R^{a4} being an organic group represented by the following general formula (1) and at least one of R^{a1}, R^{a2}, R^{a3}, and R^{a4} being a silicon-containing organic group represented by the following general formula (2); and "n" represents 1 to 30.

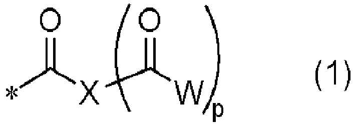

In the general formula (1), X represents an organic group having 1 to 31 carbon atoms and having a valency of p+1; W represents any structure represented by one of the general formulae (W-1); "p" represents 1 to 4; and "*" represents an attachment point to an oxygen atom.

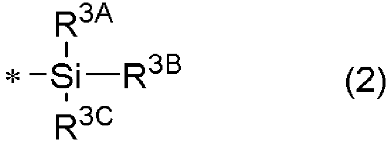

In the general formula (2), R^{3A}, R^{3B}, and R^{3C} each represent any organic group selected from an organic group having 2 to 30 carbon atoms and having a crosslinking group of any structure represented by one of the following general formulae (c-1) to (c-3), a substituted or unsubstituted alkyl group having 1 to 20 carbon atoms, and an aryl group having 6 to 20 carbon atoms; and "*" represents an attachment point to an oxygen atom.

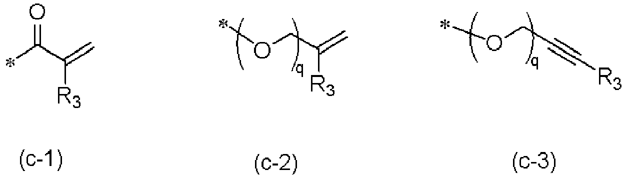

In the general formulae (c-1) to (c-3), R₃ represents a hydrogen atom or a monovalent organic group having 1 to 10 carbon atoms; "q" represents 0 or 1; and "*" represents an attachment point.

In the general formula (A), "n" represents 1 to 30, preferably 1 to 10, and in view of the availability of raw materials, further preferably 1 to 4. In the general formula (A), the organic group represented by the general formula (1) is preferably contained in an amount of 10 mol% to 90 mol%, more preferably 30 mol% to 70 mol% of the total of R^{a1}, R^{a2}, R^{a3}, and R^{a4}. The silicon-containing organic group shown by the general formula (2) is preferably contained in an amount of 10 mol% to 90 mol%, more preferably 30 mol% to 70 mol% of the total of R^{a1}, R^{a2}, R^{a3}, and R^{a4}. The alkyl group having 1 to 10 carbon atoms is preferably contained in an amount of 0 mol% to 50 mol%, more preferably 0 mol% to 20 mol% of the total of R^{a1}, R^{a2}, R^{a3}, and R^{a4}.

In the general formula (1), X represents an organic group having 1 to 31 carbon atoms and having a valency of p+1, and in view of thermosetting property, preferably represents a saturated hydrocarbon group having 1 to 20 carbon atoms or an unsaturated hydrocarbon group having 2 to 20 carbon atoms. Meanwhile, "p" preferably represents 1 to 4, and in view of productivity, more preferably 1 to 2, and particularly preferably 1.

From the viewpoints of thermosetting property and etching resistance, the X in the general formula (1) particularly preferably represents one of the following general formulae (3).

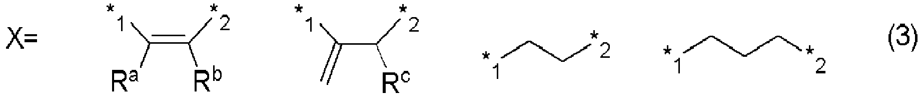

In the general formulae (3), R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.

The following structures can be given as specific examples of the X in the general formulae (3), but the examples are not limited thereto. Depending on the structure, geometrical isomers (cis isomer and trans isomer) regarding a double bond may exist in some cases, and in such a case, the isomers will be represented by a single formula. One of the isomers may be used, or the isomers may be used in combination.

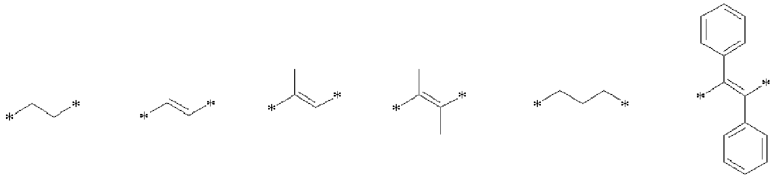

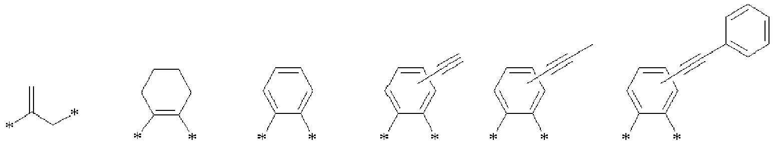

In view of etching resistance, the following structures are particularly favorable.

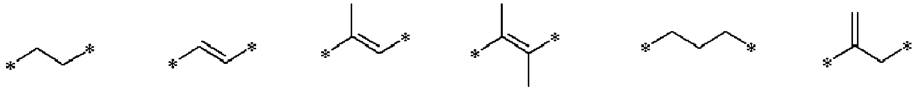

When the X in the general formulae (3) has a structure shown above, the contained amount of organic components constituting the compound for forming a metal-containing film is reduced. When a metal-containing film is formed using such a compound, the amount of organic components in the film is small, and therefore, it is possible to provide a resist underlayer film having better etching resistance.

The inventive compound for forming a metal-containing film has a crosslinking group represented by one of the general formulae (W-1), and has excellent heat resistance and thermosetting property. Thus, it is possible to suppress the volume shrinkage during baking that causes voids at the time of the filling of a stepped substrate. Furthermore, since the organic group represented by the general formula (1) has favorable heat resistance, the crosslinking reaction of the crosslinking group W, which is positioned at an end of an organic group, is facilitated. Thus, a dense cured film can be formed.

In the formula (2), R^{3A}, R^{3B}, and R^{3C} each represent any organic group selected from an organic group having 2 to 30 carbon atoms and having a crosslinking group of any structure represented by one of the general formulae (c-1) to (c-3), a substituted or unsubstituted alkyl group having 1 to 20 carbon atoms, and an aryl group having 6 to 20 carbon atoms, more preferably an organic group having 2 to 30 carbon atoms and having a crosslinking group of any structure represented by one of the general formulae (c-1) to (c-3) or an unsubstituted alkyl group having 1 to 10 carbon atoms. Out of the unsubstituted alkyl groups having 1 to 10 carbon atoms, a methyl group or an ethyl group is more preferable.

In the general formulae (c-1) to (c-3), each R₃ independently represents a hydrogen atom or a monovalent organic group having 1 to 10 carbon atoms, and each "q" independently represents 0 or 1.

In view of thermosetting property, the silicon-containing organic group of the general formula (2) more preferably has a structure represented by one of the following general formulae (2A).

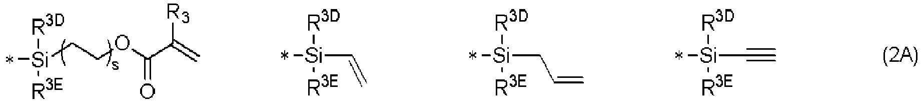

In the general formulae (2A), R^{3D} and R^{3E} each represent an organic group selected from a substituted or unsubstituted alkyl group having 1 to 20 carbon atoms and an aryl group having 6 to 20 carbon atoms; R₃ is as defined above; "s" represents 1 to 10; and "*" represents an attachment point to an oxygen atom.

In the general formulae (2A), R^{3D} and R^{3E} more preferably represent a methyl group in view of the availability of raw materials.

When a crosslinking group is contained in both the organic group and the silicon-containing organic group constituting the R^{a1}, R^{a2}, R^{a3}, and R^{a4} in the general formula (A), the thermosetting property of the compound for forming a metal-containing film can be improved further. When the compound is contained in a composition for forming a metal-containing film, it is possible to form a metal-containing film excellent in filling and planarizing properties. Accordingly, in the compound for forming a metal-containing film, preferably an organic group constituting at least one of R^{a1}, R^{a2}, R^{a3}, and R^{a4} is an organic group represented by the general formula (1), and the silicon-containing organic group constituting at least one of R^{a1}, R^{a2}, R^{a3}, and R^{a4} has a structure represented by one of the formulae (2A).

The compound for forming a metal-containing film can contain a metal compound having a structure shown below or a mixture of compounds having the structures. The compounds can contain a repeating unit designated by "n" (the number of the repeating units), an organic group represented by the general formula (1), and a silicon-containing organic group shown by the general formula (2).

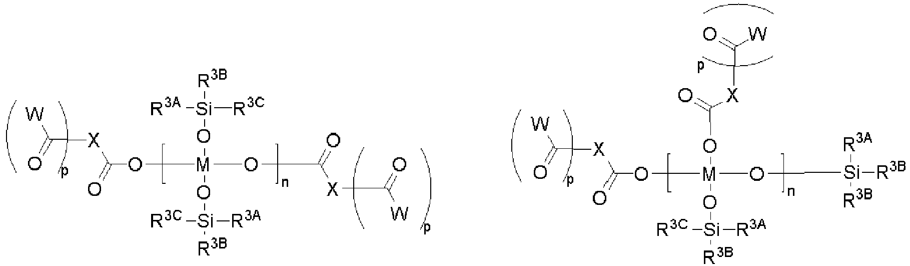

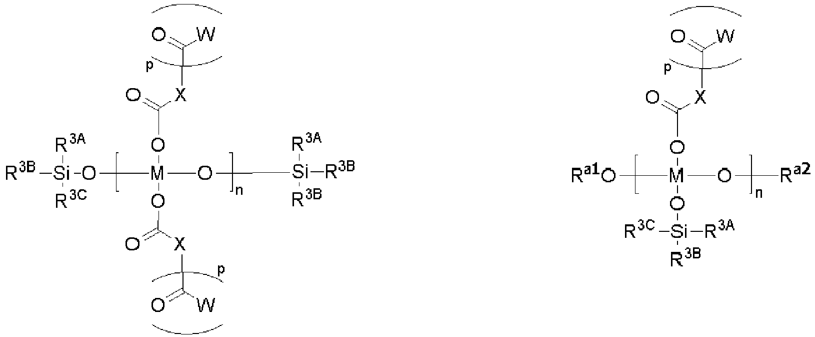

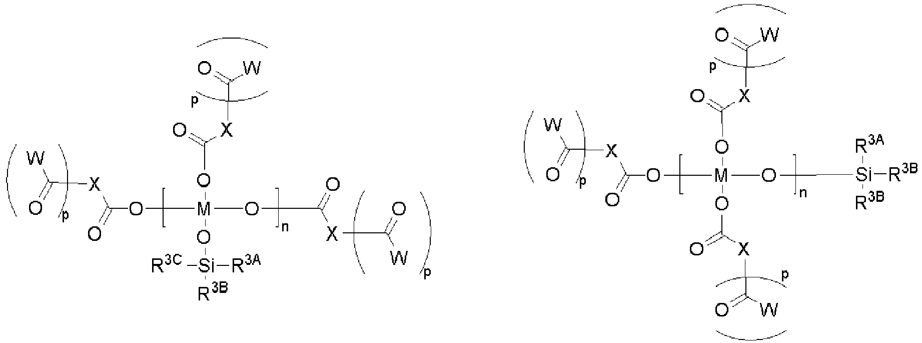

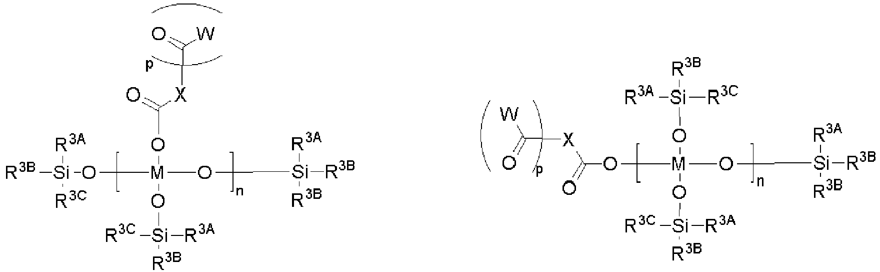

In the compound for forming a metal-containing film, the metal atom may be modified by an organic group shown by the general formula (1) having a different structure, and the compound can be adjusted appropriately depending on required properties.

The compound for forming a metal-containing film is manufactured from metal alkoxide or acetylacetonate (acac) of the above groups. Alkoxide or acac metal allows an SiOH-containing compound to react to generate a silicon-containing organic group of the general formula (2), and then reacts with an anhydride, a cyclic anhydride or a carboxylic acid to generate an organic group of the general formula (1). Any alkyl group having 1 to 10 carbon atoms that can constitute some of the R^{a1}, R^{a2}, R^{a3}, and R^{a4} groups in the compound for forming a metal-containing film is generated as a result of using remaining alkoxide or a metal alkoxide precursor or is generated as a result of using an alcohol having 1 to 10 carbon atoms as an additional reagent in manufacturing the compound for forming a metal-containing film. The reaction is carried out in a solvent that can dissolve the alkoxide or acac precursor and other reagents. Typical solvents and solvent mixtures include esters, ethers, and alcohol functional groups, for example, a mixture of propylene glycol monomethyl ether acetate (PGMEA) and propylene glycol monomethyl ether (PGME) at 70/30 in volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### <Composition for Forming Metal-Containing Film>

The present invention can also provide a composition for forming a metal-containing film containing: (A) the above-described compound for forming a metal-containing film; and (B) an organic solvent.

Such a composition for forming a metal-containing film contains a compound for forming a metal-containing film, the compound having high levels of both thermal flowability and thermosetting property, and therefore, can provide a resist material having better dry etching resistance than conventional resist underlayer film materials and also having high filling and planarizing properties.

In the following, the components contained in the inventive composition for forming a metal-containing film other than the compound (A) for forming a metal-containing film will be described.

### <(B) Organic Solvent>

The organic solvent (B) usable in the inventive composition for forming a metal-containing film is not particularly limited as long as the solvent can dissolve or disperse the compound (A) for forming a metal-containing film and, when contained, (C) a crosslinking agent, (B1) a high-boiling-point solvent, (E) a surfactant, (F) an acid generator, (G) metal oxide nanoparticles having an average primary particle size of 100 nm or less, other additives, etc. described below.

Specifically, an organic solvent disclosed in paragraphs [0091] and [0092] in JP2007-199653A may be contained. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the compound (A) for forming a metal-containing film.

The composition can contain one or more of the compound (A) for forming a metal-containing film and one or more of the organic solvent (B), and as necessary, the composition may contain additives such as a crosslinking agent (C), a high-boiling-point solvent (B1), a surfactant (E), an acid generator (F), and metal oxide nanoparticles (G) having an average primary particle size of 100 nm or less.

In the following, the components contained in the inventive composition for forming a metal-containing film other than the compound (A) for forming a metal-containing film and the organic solvent (B) will be described.

### <(B1) High-Boiling-Point Solvent>

In the inventive composition for forming a metal-containing film, the organic solvent (B) may be a mixture of one or more kinds of organic solvent having a boiling point of lower than 180°C and one or more kinds of organic solvent having a boiling point of 180°C or higher ((B1) a high-boiling-point solvent). That is, the organic solvent (B) preferably includes, as a high-boiling-point solvent (B1), one or more kinds of organic solvent having a boiling point of 180°C or higher.

The high-boiling-point solvent (B1) is not particularly limited to hydrocarbons, alcohols, ketones, esters, ethers, or chlorine-based solvents as long as the solvent is capable of dissolving or dispersing the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycoln-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the composition of the present invention for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent, having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### [(C) Crosslinking Agent]

To increase the curability of the compound for forming a metal-containing film and further inhibit intermixing with the resist upper layer film, the inventive composition for forming a metal-containing film may also contain a crosslinking agent (C). The crosslinking agent is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The crosslinking agent (C) is preferably contained in an amount of 5 to 50 parts by mass, more preferably 10 to 40 parts by mass relative to 100 parts by mass of the compound (A) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

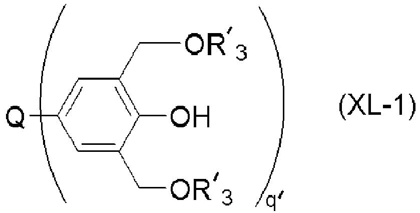

In the general formula (XL-1), Q represents a single bond or a q'-valent hydrocarbon group having 1 to 20 carbon atoms. R'₃ represents a hydrogen atom or an alkyl group having 1 to 20 carbon atoms. "q'" represents an integer of 1 to 5.

Q represents a single bond or a hydrocarbon group having a valency of "q'" and having 1 to 20 carbon atoms. "q'" represents an integer of 1 to 5, more preferably 2 or 3. Specific examples of Q include groups obtained by removing "q'" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R'₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are preferable from the viewpoint of improving the curability and film thickness uniformity of the metal-containing film. R'₃ is as defined above.

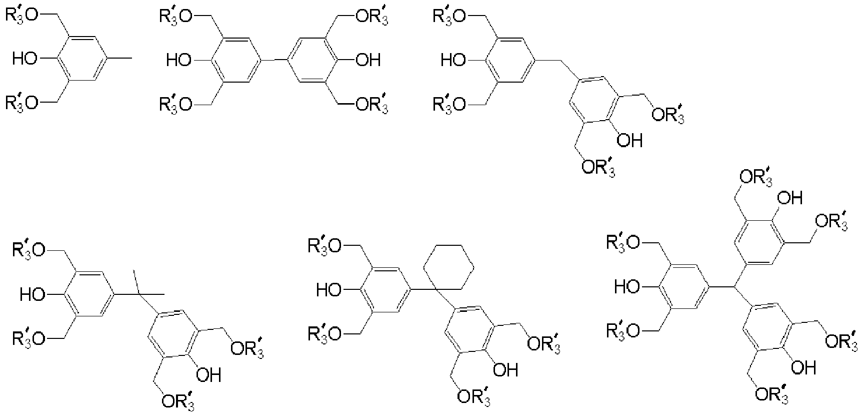

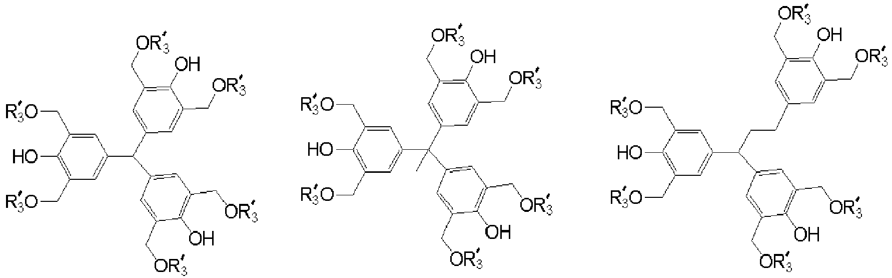

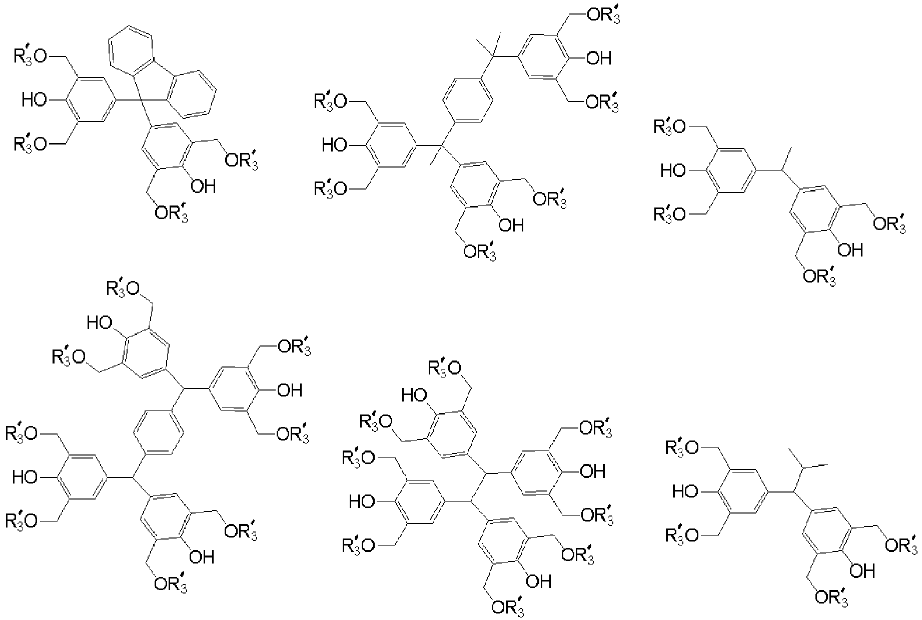

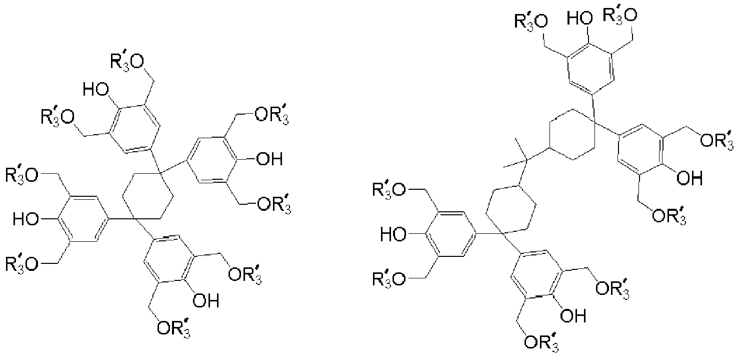

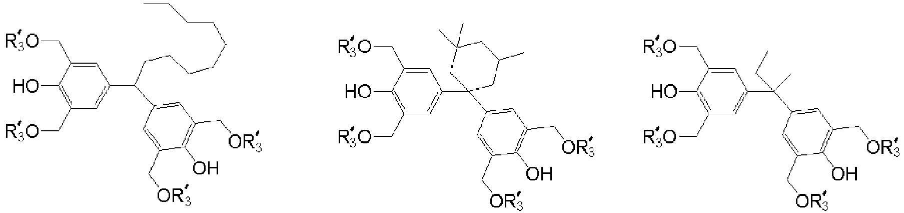

### <(E) Surfactant>

A surfactant (E) may be contained in the inventive composition for forming a metal-containing film in order to improve coating property in spin-coating. Examples of the surfactant include those disclosed in paragraphs [0142] to [0147] of JP2009-269953A. When the surfactant is contained, the contained amount is preferably 0.01 to 10 parts by mass, more preferably 0.05 to 5 parts by mass per 100 parts by mass of the compound (A) for forming a metal-containing film.

### <(F) Acid Generator>

An acid generator may be contained in the inventive composition for forming a metal-containing film in order to promote the curing reaction of the compound (A) for forming a metal-containing film further. The acid generator can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When an acid generator is contained, the contained amount is preferably 0.05 to 50 parts by mass, more preferably 0.1 to 10 parts by mass relative to 100 parts by mass of the compound (A) for forming a metal-containing film.

### <(G) Metal Oxide Nanoparticles>

The inventive composition for forming a metal-containing film can also contain metal oxide nanoparticles (G) in order to improve dry etching resistance further. Specifically, metal oxide nanoparticles selected from the group consisting of zirconium oxide nanoparticles, hafnium oxide nanoparticles, titanium oxide nanoparticles, tin oxide nanoparticles, and tungsten oxide nanoparticles are preferable.

By selecting such metal oxide nanoparticles, it is possible to form a metal-containing film having better dry etching resistance.

The metal oxide nanoparticles (G) preferably have an average primary particle size of 100 nm or less, more preferably an average primary particle size of 50 nm or less, further preferably an average primary particle size of 30 nm or less, and particularly preferably an average primary particle size of 15 nm or less. The average primary particle size of the metal oxide nanoparticles before being dispersed in an organic solvent can be determined by a method of measuring the size of primary particles directly from an electron microscope photograph. Specifically, the minor axis diameter and the major axis diameter of each primary particle are measured, and the average of the values is defined as the particle size of the particle. Then, for 100 or more particles, the volume (mass) of each particle is approximated to a cuboid of the determined particle size, and this volume average particle size is determined as the average particle size. Identical results can be obtained when any of a transmission type electron microscope (TEM), a scanning type electron microscope (SEM), or a scanning transmission type electron microscope (STEM) are used.

When the particle size is within such ranges, the particles can exhibit excellent dispersity in a composition for forming a metal-containing film, and can enhance the dry etching resistance of a metal-containing film without causing the degradation of filling and planarizing properties in dense portions of a fine pattern structure. When the metal oxide nanoparticles (G) are contained, the contained amount is preferably 5 to 50 parts by mass, more preferably 5 to 30 parts by mass per 100 parts by mass of the compound (A) for forming a metal-containing film.

### <Other Additives>

In addition, in the inventive composition for forming a metal-containing film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more at 30°C to 250°C and a weight-average molecular weight of 300 to 200,000. This thermo-decomposable polymer preferably contains a repeating unit having an acetal structure represented by the following general formula (DP1) or (DP1a).

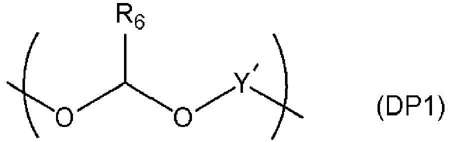

In the general formula (DP1), R₆ represents a hydrogen atom or an optionally substituted saturated or unsaturated monovalent organic group having 1 to 30 carbon atoms. Y' represents a saturated or unsaturated divalent organic group having 2 to 30 carbon atoms.

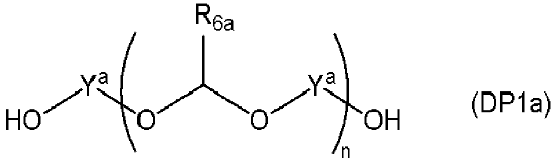

In the general formula (DP1a), R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Flowability Accelerator (BP)>

A flowability accelerator (BP) may be contained in the inventive composition for forming a metal-containing film as an additive for providing filling and planarizing properties. The flowability accelerator (BP) preferably has one of the organic groups represented by the following general formulae (3') and an aromatic ring.

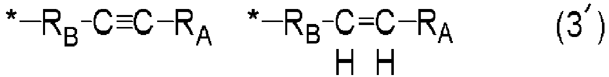

In the general formulae (3'), "*" represents an attachment point to an oxygen atom. R_{B} represents a divalent organic group having 1 to 10 carbon atoms. R_{A} represents a hydrogen atom or a monovalent organic group having 1 to 10 carbon atoms.

When the flowability accelerator (BP) contains the organic group represented by one of the general formulae (3'), thermal flowability and thermosetting property can be imparted to the compound for forming a metal-containing film. Furthermore, when the flowability accelerator (BP) has an aromatic ring, degradation of the compound for forming a metal-containing film in dry etching resistance can be alleviated.

The flowability accelerator (BP) preferably has at least one constitutional unit represented by the following general formulae (BP-1), (BP-2), (BP-3), (BP-4), and (BP-5).

### (Constitutional Units: BP-1, BP-2, and BP-3)

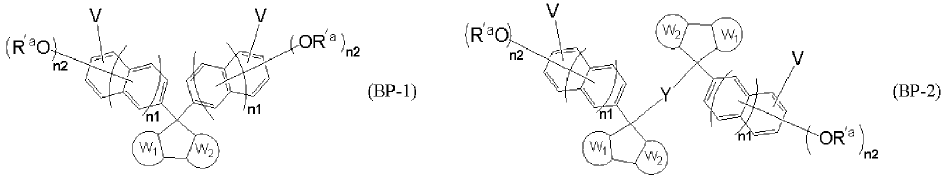

In the general formulae (BP-1) and (BP-2), W₁ and W₂ each independently represent a benzene ring or a naphthalene ring, part of hydrogen atoms in the benzene ring and the naphthalene ring optionally being substituted with a hydrocarbon group having 1 to 6 carbon atoms. Each R'^{a} independently represents a group represented by one of the following formulae (4). Y represents a group represented by one of the following formulae (5). Each "n₁" independently represents 0 or 1. Each "n₂" independently represents 1 or 2. Each V independently represents a hydrogen atom or an attachment point.

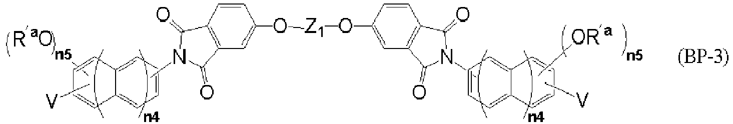

In the general formula (BP-3), Z₁ represents a group represented by one of the following general formulae (6). Each R'^{a} independently represents either group represented by the following formulae (4). Each "n₄" independently represents 0 or 1. Each "n₅" independently represents 1 or 2. Each V independently represents a hydrogen atom or an attachment point.

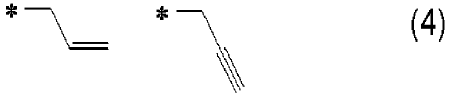

In the formulae (4), "*" represents an attachment point to an oxygen atom.

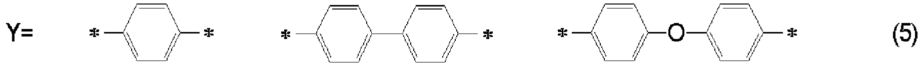

In the formulae (5), "*" represents an attachment point.

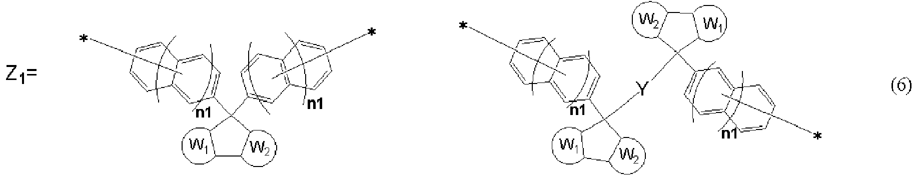

In the general formulae (6), W₁, W₂, Y, and "n₁" are as defined above; and "*" represents an attachment point.

A resin having a constitutional unit represented by the general formulae (BP-1), (BP-2), and (BP-3) has excellent heat resistance, since a condensed carbon ring having a high carbon density including a cardo structure is introduced to the resin. Because the resin has such a characteristic, it is possible to form a metal-containing film that can fill a stepped substrate without generating voids even when baked at a high temperature. Moreover, the resin is also excellent in dry etching resistance, and therefore, when the resin is contained in the inventive composition for forming a metal-containing film, heat resistance and thermal flowability can be imparted without great degradation of the excellent dry etching resistance that the composition for forming a metal-containing film has.

The resin having a constitutional unit represented by the general formulae (BP-1), (BP-2), and (BP-3) can be a compound represented by the following general formulae (bp-1), (bp-2), and/or (bp-3).

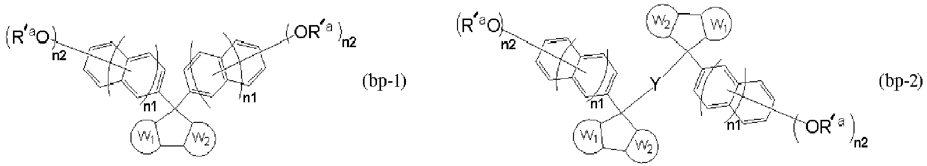

In the general formulae (bp-1) and (bp-2), W₁, W₂, R'^{a}, Y, "n₁", and "n₂" are as defined above.

The W₁, W₂, R'^{a}, Y, "n₁", and "n₂" in the general formulae (bp-1) and (bp-2) are as described in the description of the general formulae (BP-1) and (BP-2).

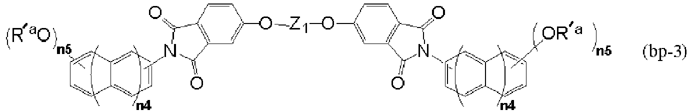

In the general formula (bp-3), Z₁, R'^{a}, "n₄", and "n₅" are as defined above.

The Z₁, R'^{a}, "n₄", and "n₅" in the general formula (bp-3) are as described in the description of the general formula (BP-3).

Specific examples of resins having a constitutional unit shown by the general formulae (bp-1), (bp-2), and (bp-3) include the following compounds, but are not limited thereto.

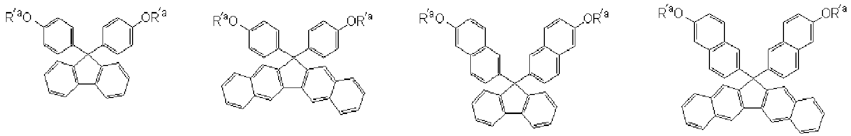

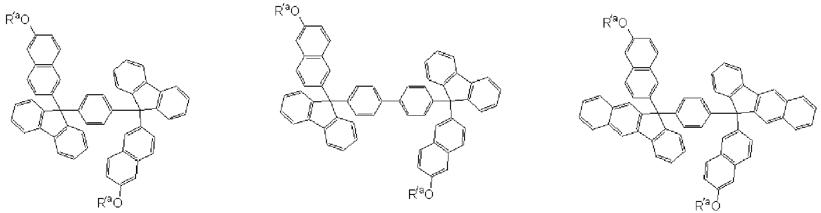

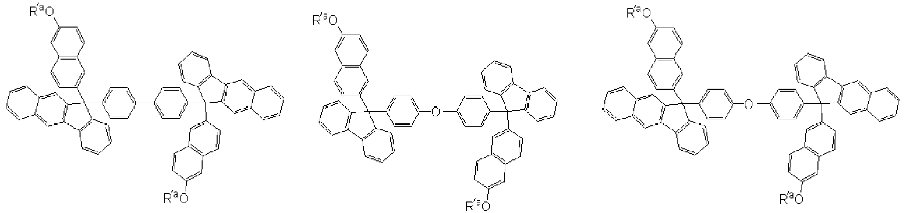

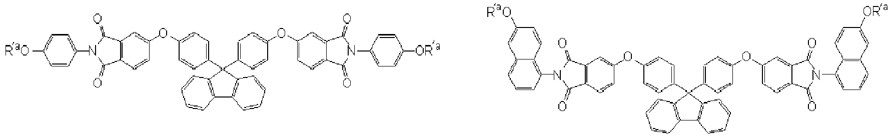

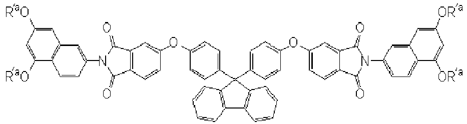

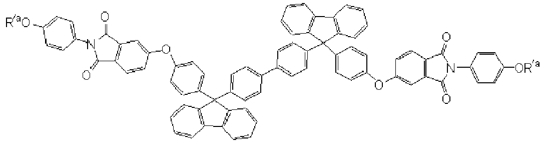

The Mw/Mn (that is, the dispersity) of the compounds shown by the general formulae (bp-1), (bp-2), and (bp-3) is preferably within the range of 1.00 ≤ Mw/Mn ≤ 1.25, further preferably 1.00 ≤ Mw/Mn ≤ 1.10, where Mw is a weight-average molecular weight and Mn is a number-average molecular weight measured by gel permeation chromatography in terms of polystyrene.

A compound having a dispersity within such a range provides the composition for forming a metal-containing film with even better thermal flowability. Thus, it is possible to provide a composition for forming a metal-containing film having even better filling and planarizing properties when the compound is contained in the composition.

The resin having a constitutional unit represented by the general formulae (BP-1), (BP-2), and (BP-3) may be a polymer having a repeating unit represented by the following general formulae (bp-4), (bp-5), and/or (bp-6).

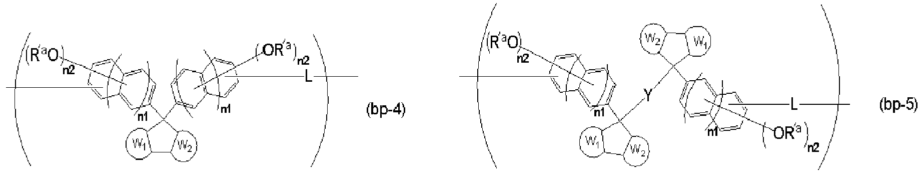

In the general formulae (bp-4) and (bp-5), W₁, W₂, R'^{a}, Y, "n₁", and "n₂" are as defined above, and L represents a divalent organic group having 1 to 40 carbon atoms.

The W₁, W₂, R'^{a}, Y, "n₁", and "n₂" in the general formulae (bp-4) and (bp-5) are as described in the description of the general formulae (BP-1) and (BP-2).

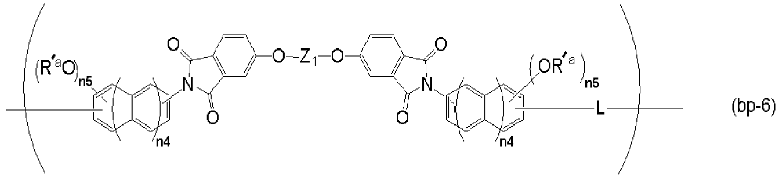

In the general formula (bp-6), Z₁, R'^{a}, "n₄", and "n₅" are as defined above, and L represents a divalent organic group having 1 to 40 carbon atoms.

The Z₁, R'^{a}, "n₄", and "n₅" in the general formula (bp-6) are as described in the description of the general formula (BP-3).

The polymer is obtained with compounds represented by the general formulae (bp-1), (bp-2), and (bp-3), and because the compounds are used, the polymer has excellent dry etching resistance and heat resistance. In addition, since the polymer is not a monomer but a polymer having repeating units, the amount of outgas component is small, and the polymer has a molecular weight distribution; therefore, crystallinity is alleviated, and improved film forming property can also be expected.

L, which is a linking group contained in the repeating units of the general formulae (bp-4), (bp-5), and (bp-6), is a divalent organic group having 1 to 40 carbon atoms, and specific examples include the following.

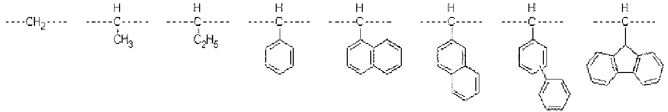

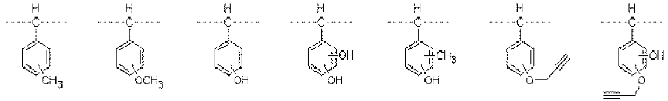

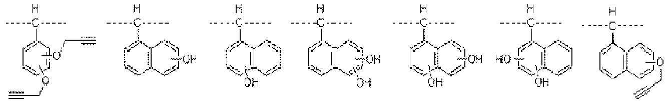

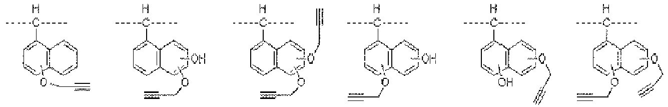

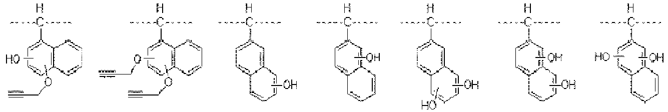

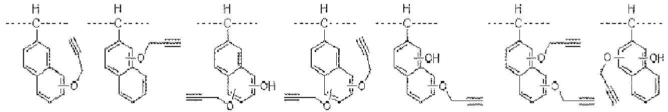

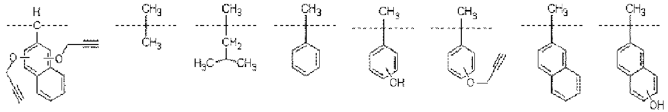

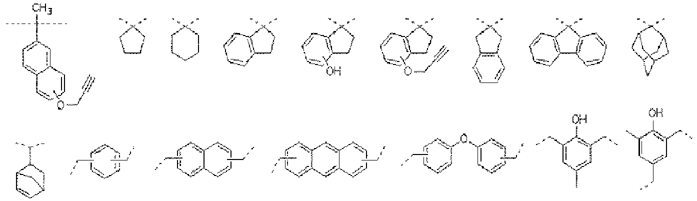

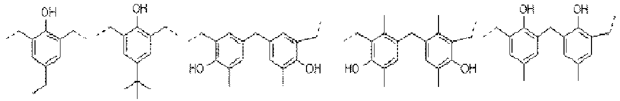

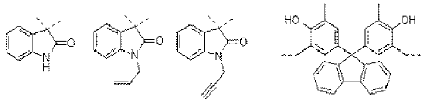

Furthermore, the linking group L of the polymer is preferably a group represented by the following general formula (10).

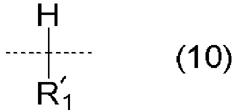

In the general formula (10), R'₁ represents a hydrogen atom or an organic group having 6 to 20 carbon atoms and including an aromatic ring, and a broken line represents an attachment point.

Specific examples of the general formula (10) include the following. In particular, in view of the availability of raw materials, a methylene group is preferable, that is, R'₁ is preferably a hydrogen atom.

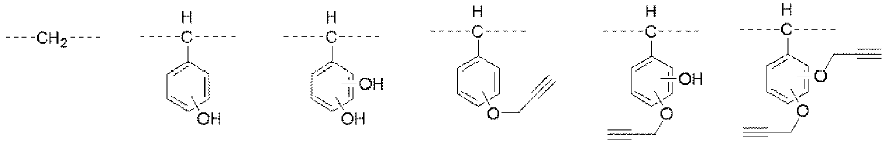

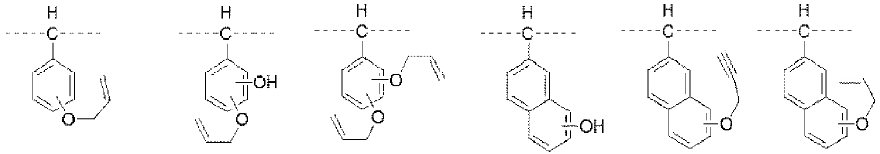

Furthermore, the polymer having the repeating units represented by the general formulae (bp-4), (bp-5), and (bp-6) preferably has a weight-average molecular weight (Mw) of 1,000 to 12,000, further preferably 2,000 to 10,000 as measured by gel permeation chromatography in terms of polystyrene.

When the molecular weight is within such a range, solubility in an organic solvent can be ensured, and it is possible to suppress sublimation products that are generated during baking. Furthermore, the thermal flowability of the composition for forming a metal-containing film is improved, and therefore, it is possible to provide a composition for forming a metal-containing film having better filling and planarizing properties when the polymer is contained in the composition.

### (Constitutional Unit: BP-4)

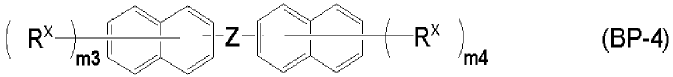

In the general formula (BP-4), "m₃" and "m₄" each independently represent 1 or 2. Z represents a single bond or any structure represented by the following general formulae (7). Each R^{x} independently represents any structure represented by the following general formulae (8).

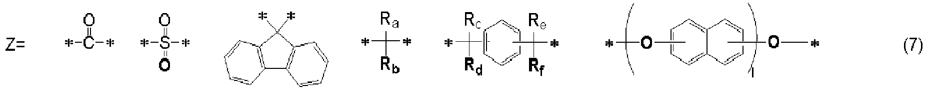

In the general formulae (7), "*" represents an attachment point. "l" represents an integer of 0 to 3. Rₐ to R_{f} each independently represent a hydrogen atom, an alkyl group having 1 to 10 carbon atoms and optionally having a substituent fluorine atom, a phenyl group, or a phenylethyl group, Rₐ and R_{b} optionally being bonded to each other to form a cyclic compound.

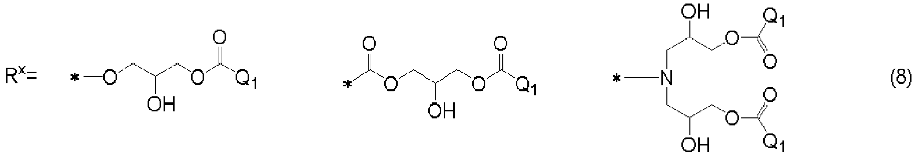

In the general formulae (8), "*" represents an attachment point to an aromatic ring. Each Q₁ represents a linear saturated hydrocarbon group having 1 to 30 carbon atoms or a structure represented by the following general formula (9).

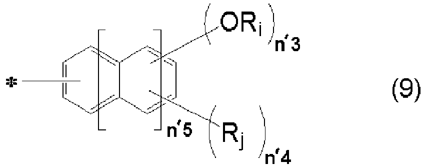

In the general formula (9), "*" represents an attachment point to a carbonyl group. Rᵢ represents either group represented by the formulae (4). Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms. "n'₃" and "n'₄" each represent a number of substituents on an aromatic ring, the number each representing an integer of 0 to 7, provided that n'₃+n'₄ is 0 or more and 7 or less. "n'₅" represents 0 to 2.

In the general formula (BP-4), "m₃" and "m₄" each independently represent 1 or 2, and Z represents a single bond or one of the structures represented by the general formulae (7). Each R^{x} independently represents one of the structures represented by the general formulae (8).

From the viewpoint of dry etching resistance and heat resistance, the Z in the general formula (BP-4) is preferably a single bond or one of the structures represented by the following formulae (4A).

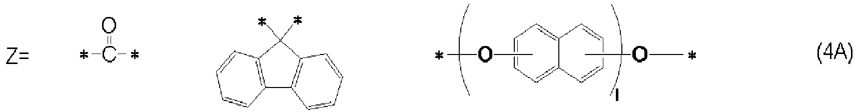

In the formulae (4A), "*" represents an attachment point, and "l" is as defined in the general formulae (7).

In the general formulae (8), "*" represents an attachment point to an aromatic ring. Q₁ represents a linear saturated hydrocarbon group having 1 to 30 carbon atoms or a structure represented by the general formula (9). When Q₁ represents a linear hydrocarbon group having 1 to 30 carbon atoms, methylene groups constituting Q₁ may be substituted with an oxygen atom or a carbonyl group. From the viewpoints of dry etching resistance and heat resistance, Q₁ is preferably a structure represented by the general formula (9).

In the general formula (9), "*" represents an attachment point to a carbonyl group, and Rᵢ represents one of the groups represented by the formulae (4). Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms. "n'₃" and "n'₄" each represent the number of substituents on an aromatic ring, and each represent an integer of 0 to 7, provided that n'₃+n'₄ is 0 or more and 7 or less. "n'₅" represents 0 to 2.

A compound containing a constitutional unit represented by the general formula (BP-4) has a structure in which aromatic rings are linked by a single bond or one of the general formulae (7), and therefore, has a high carbon density. Accordingly, a composition for forming a metal-containing film containing such a compound has excellent heat resistance. Meanwhile, the structure of the linking group Z can be selected appropriately from various linking groups in accordance with the desired performance, as shown in the formulae (7). In particular, by introducing a structure represented by one of the formulae (4A) as the Z, heat resistance and etching resistance can be provided without film forming property being degraded. Moreover, since the compound has a highly flexible terminal moiety R^{x}, the composition for forming a metal-containing film can be formed into a thick film without generating defects such as cracks, even though the compound includes a rigid aromatic ring structure. Furthermore, the terminal moiety R^{x} includes a terminal group Q₁ that provides thermal flowability. As the terminal group Q₁, it is possible to introduce at any proportion a flexible hydrocarbon structure that contributes to the improvement of thermal flowability and a rigid aromatic ring structure that contributes to etching resistance and heat resistance, depending on the required performance. As described above, a composition for forming a metal-containing film containing such a compound can realize high levels of filling and planarizing properties and heat resistance, and in accordance with required properties, a thick film can be formed.

### (Constitutional Unit: BP-5)

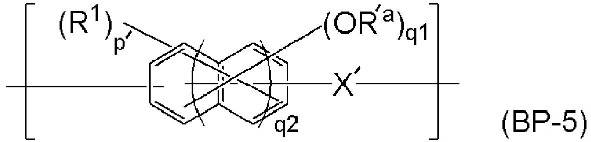

In the general formula (BP-5), R¹ represents a saturated monovalent organic group having 1 to 30 carbon atoms or an unsaturated monovalent organic group having 2 to 30 carbon atoms. X' represents a divalent organic group having 1 to 30 carbon atoms. R'^{a} represents either group represented by the formulae (4). "p'" represents an integer of 0 to 5 and "q₁" represents an integer of 1 to 6, provided that p'+q₁ is an integer of 1 or more and 6 or less. "q₂" represents 0 or 1.

Examples of the divalent organic group having 1 to 30 carbon atoms represented by X' in the general formula (BP-5) include: alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (a dicyclopentylene group), a tricyclo[3.3.1.1^{3,7}]decanediyl group, a tetracyclo[6.2.1.1^{3,6}.0^{2,7}]dodecanediyl group, and an adamantanediyl group; and arenediyl groups, such as a phenylene group and a naphthylene group.

Examples of alkanediyloxy groups represented by the X' include groups containing a combination of the above alkanediyl group and an oxygen atom. Meanwhile, examples of cycloalkanediyloxy groups represented by the X' include groups containing a combination of the above cycloalkanediyl group and an oxygen atom.

Part or all of the hydrogen atoms in the alkanediyl groups, cycloalkanediyl groups, alkanediyloxy groups, cycloalkanediyloxy groups, arenediyl groups, etc. may be substituted, and examples of substituents include the groups that are examples of substituents that the organic group represented by R'^{a} may have.

Examples of the organic group represented by X' include groups represented by the following formulae and so forth.

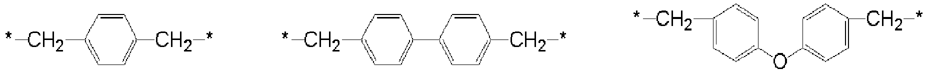

In the formulae, "*" represents an attachment point.

The X' is preferably a methylene group from the viewpoint of the availability of raw materials.

Specific examples of the resin having a structural unit represented by the general formula (BP-5) include the following.

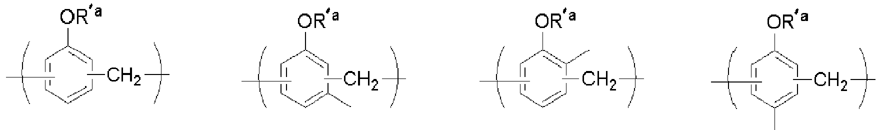

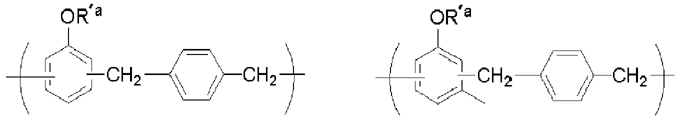

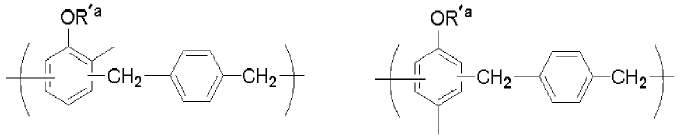

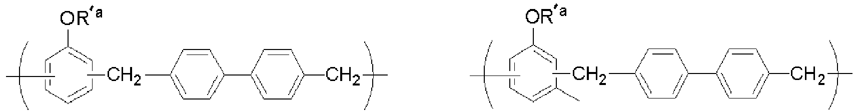

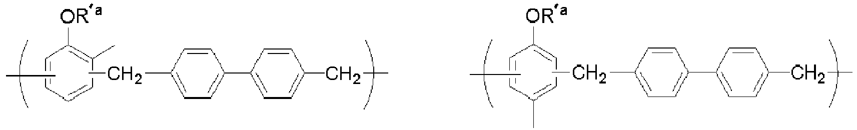

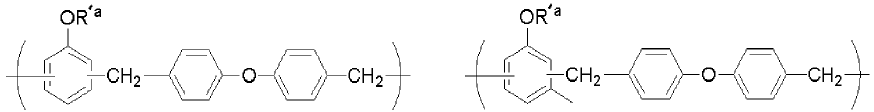

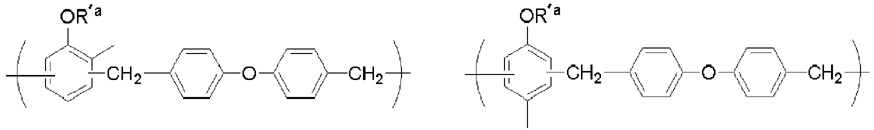

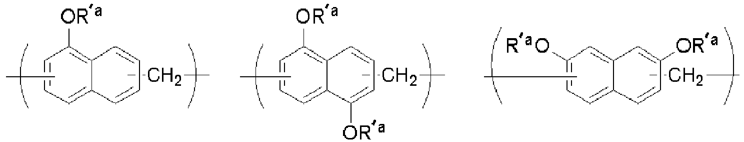

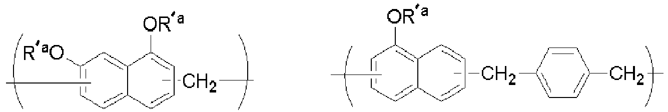

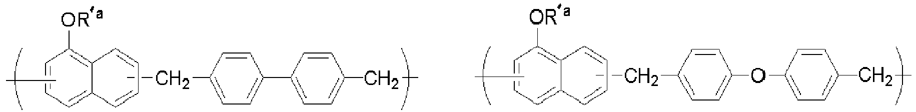

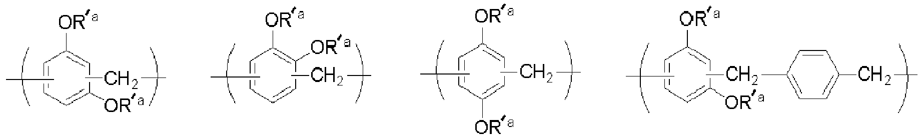

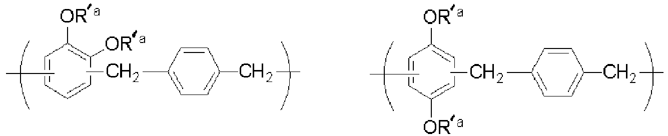

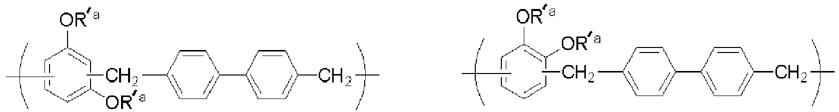

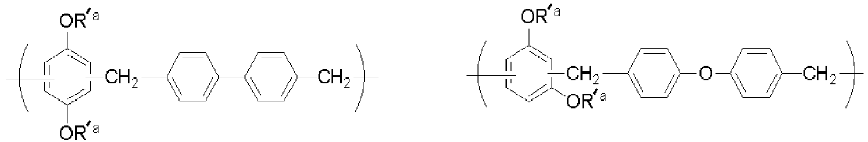

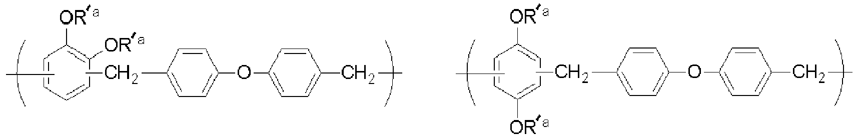

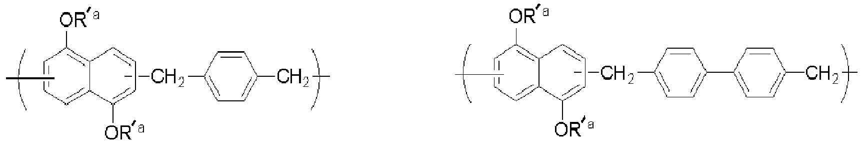

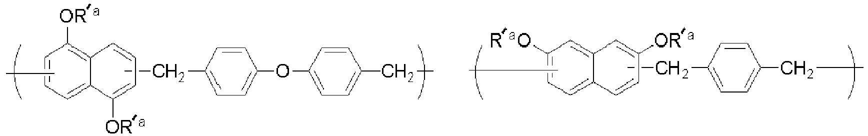

In the formulae, R'^{a} is as defined above.

A polymer containing the constitutional unit represented by the general formula (BP-5) has a structure in which aromatic rings are linked by an organic group (X'), and has a high carbon density. Accordingly, a composition for forming a metal-containing film containing such a polymer exhibits high dry etching resistance, and also has excellent heat resistance. Furthermore, an organic group, which contributes to the improvement of thermal flowability, having a structure represented by one of the formulae (4) is bonded directly to an aromatic ring via an oxygen atom, the aromatic ring being a mother nucleus structure of the resin. Therefore, a composition for forming a metal-containing film containing such a polymer can achieve high levels of filling and planarizing properties, and also of heat resistance and etching resistance. Furthermore, the aromatic ring structure of the mother nucleus is not excessively rigid, and forms a repeating structure through the organic group (X'), being a linking group, and therefore, a composition for forming a metal-containing film can be formed without generating defects such as cracks.

In the inventive composition for forming a metal-containing film, the flowability accelerator (BP) is preferably contained in an amount of 50% by mass or less, more preferably 30% by mass or less, and further preferably 20% by mass or less based on 100 parts by mass of the compound for forming a metal-containing film.

The amount of the flowability accelerator to be contained can be adjusted to any proportion, depending on the properties required in the process in which the inventive composition for forming a metal-containing film is used. When it is desired to minimize the degradation of dry etching resistance, the proportion of the flowability accelerator can be reduced. When the degradation of dry etching resistance can be tolerated to some extent, and it is desired to improve the filling and planarizing properties further, the proportion of the flowability accelerator can be increased.

### <Methods for Forming Resist Underlayer Film and Filling Film>

The present invention provides a method for forming, by using the above-described composition for forming a metal-containing film, a resist underlayer film of a multilayer resist film used in lithography or a filling film that serves as a planarizing film for the manufacture of a semiconductor.

In the method for forming a resist underlayer film by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing of the resist underlayer film with the resist upper layer film or the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film as a resist underlayer film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1,000 ppm or less, more preferably 100 ppm or less (volumetric basis). By thus preventing oxidation of the metal-containing film during the baking, the absorption does not increase and the etching resistance does not decrease, which is preferable.

The method for forming a filling film can be similar to the method for forming a resist underlayer film.

### <Patterning Process Using Composition for Forming Metal-Containing Film>

The present invention provides, as a patterning process according to a two-layer resist process using the above-described composition for forming a metal-containing film, a patterning process for forming a pattern in a substrate to be processed, including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention also provides, as a patterning process according to a three-layer resist process using the above-described composition for forming a metal-containing film, a patterning process for forming a pattern in a substrate to be processed, including the steps of:
(II-1) applying the above-described composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

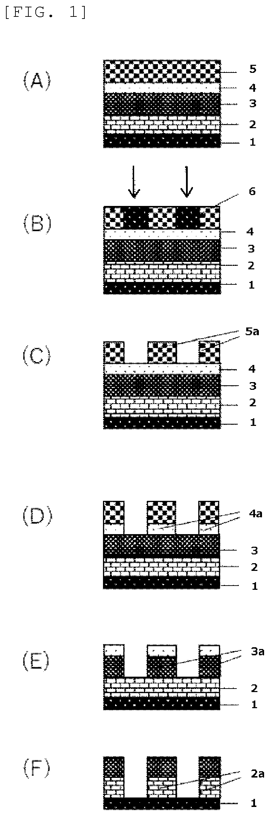

With reference to FIG. 1, a patterning process according to a three-layer resist process will be described. The present invention provides, as a patterning process according to a three-layer resist process using such a composition for forming a metal-containing film, the patterning process including:
forming a metal-containing film 3 on a layer 2 to be processed on a substrate 1 to be processed by using the composition for forming a metal-containing film, forming a silicon-containing resist middle layer film 4 on the metal-containing film by using a silicon-containing resist middle layer film material, and forming a resist upper layer film 5 on the silicon-containing resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a metal-containing film pattern 3a to the metal-containing film by dry etching while using the silicon-containing resist middle layer film having the transferred pattern as a mask as in FIG. 1(E); and
processing the layer to be processed on the substrate to be processed while using the metal-containing film having the formed pattern as a mask to form a pattern 2a on the substrate 1 to be processed as in FIG. 1(F).

The silicon-containing resist middle layer film in the three-layer resist process exhibits etching resistance with respect to a chlorine-based gas. Therefore, the dry etching of the metal-containing film that is performed while using the silicon-containing resist middle layer film as a mask in the three-layer resist process is preferably performed using an etching gas mainly containing a chlorine-based gas.

As the silicon-containing resist middle layer film in the three-layer resist process, a polysiloxane-based middle layer film is also preferably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides, as a patterning process by way of a four-layer resist process using such a composition for forming a metal-containing film, a patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern can be formed on a substrate, at least, by:
forming a metal-containing film on a substrate to be processed by using the inventive composition for forming a metal-containing film;
forming an inorganic hard mask middle layer film selected from a silicon oxide film, a silicon nitride film, and a silicon oxynitride film on the metal-containing film;
forming a resist upper layer film on the inorganic hard mask middle layer film by using a photoresist composition;
forming a circuit pattern in the resist upper layer film;
transferring the pattern to the inorganic hard mask middle layer film while using the resist upper layer film having the formed pattern as a mask;
transferring the pattern to the metal-containing film while using the inorganic hard mask middle layer film having the formed pattern as a mask; and
further processing the substrate to be processed while using the metal-containing film having the formed pattern as a mask to form the pattern in the substrate to be processed.

The present invention provides, as a patterning process according to a four-layer resist process using the above-described composition for forming a metal-containing film, a patterning process for forming a pattern in a substrate to be processed, including the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

As described above, when the inorganic hard mask middle layer film is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most preferably used as the inorganic hard mask middle layer film. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to a CVD method or an ALD method.

In a case where the resist upper layer film is formed by a spin-coating method, prebaking is conducted after applying the photoresist composition. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the resist upper layer film is to be formed by a deposition treatment according to a CVD method or an ALD method, the photoresist composition is a metal oxide-containing film having photosensitivity to EUV, and the metal is selected from Sn, Zr, Hf, Ti, Bi, Sb, etc. In particular, Sn, which has excellent photosensitivity to EUV, is preferable. The metal oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal oxide-containing film may be deposited by PECVD or PEALD, for example, by using a Lam Vector (registered trademark) tool, separating the Sn oxide precursor from 0 precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the metal-containing film is etched while using the obtained silicon-containing resist middle layer film pattern or inorganic hard mask middle layer film pattern as a mask. The etching of the metal-containing film is preferably performed using an etching gas mainly containing a chlorine-based gas.

The subsequent etching of a substrate to be processed may also be performed according to a usual manner. For example, in the case of a substrate to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the substrate to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

Furthermore, the present invention provides a patterning process by way of a four-layer resist process using such a composition for forming a metal-containing film, the patterning process including the steps of:
forming a metal-containing film on a substrate to be processed by using the above-described composition for forming a metal-containing film;
forming an organic underlayer film on the metal-containing film by using an organic resist underlayer film material;
forming a silicon-containing resist middle layer film on the organic underlayer film by using a silicon-containing resist middle layer film material;
if necessary, forming an organic antireflective film (BARC) or an adhesive film on the silicon-containing resist middle layer film;
forming a resist upper layer film on the silicon-containing film, on the BARC, or on the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the organic underlayer film by dry etching while using the silicon-containing resist middle layer film having the transferred pattern as a mask;
transferring the pattern to the metal-containing film while using the organic underlayer film as a mask; and
processing the substrate to be processed while using the metal-containing film having the formed pattern as a mask, thereby forming the pattern in the substrate to be processed.

As an organic resist underlayer film material that can be used for the organic underlayer film, it is possible to use: materials already known as materials for three-layer resist methods or materials for an underlayer film containing a silicon resist composition for two-layer resist methods; materials known as resist underlayer film materials for two-layer resist methods and three-layer resist methods, the materials including various resins, such as a 4,4'-(9-fluorenylidene)bisphenol novolak resin (molecular weight: 11,000) disclosed in JP2005-128509A, and also other novolak resins; etc. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic underlayer film can be formed on the substrate to be processed by using a composition solution and by a spin-coating method or the like in the same manner as the photoresist composition. After forming the organic underlayer film by a spin-coating method or the like, it is desirable to bake the substrate in order to evaporate the organic solvent. The baking temperature is preferably 80 to 400°C, and the baking time is preferably 10 to 300 seconds.

Instead of the organic underlayer film, it is also possible to adopt an organic hard mask formed by a CVD method or an ALD method.

The organic middle layer film in the multilayer resist process exhibits etching resistance with respect to chlorine-based gas. Therefore, the dry etching of the metal-containing film that is performed while using the organic middle layer film as a mask in the multilayer resist process is preferably performed using an etching gas mainly containing a chlorine-based gas.

The present invention also provides, as a patterning process according to a four-layer resist process using such a composition for forming a metal-containing film, a patterning process for forming a pattern in a substrate to be processed, including the steps of:
(IV-1) applying the above-described composition for forming a metal-containing film onto a substrate to be processed, followed by heating to form a metal-containing film;
(IV-2) forming a resist underlayer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the resist underlayer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the resist underlayer film by dry etching while using the silicon-containing resist middle layer film or the inorganic hard mask middle layer film having the transferred pattern as a mask;
(IV-8) transferring the pattern to the metal-containing film by dry etching while using the resist underlayer film having the transferred pattern as a mask; and
(IV-9) processing the substrate to be processed while using the metal-containing film having the formed pattern as a mask to form the pattern in the substrate to be processed.

### <Tone-Reversal Patterning Process Using Composition for Forming Metal-Containing Film>

Furthermore, the present invention provides, as a tone-reversal patterning process using such a composition for forming a metal-containing film, a tone-reversal patterning process for forming a pattern in a substrate to be processed, including the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

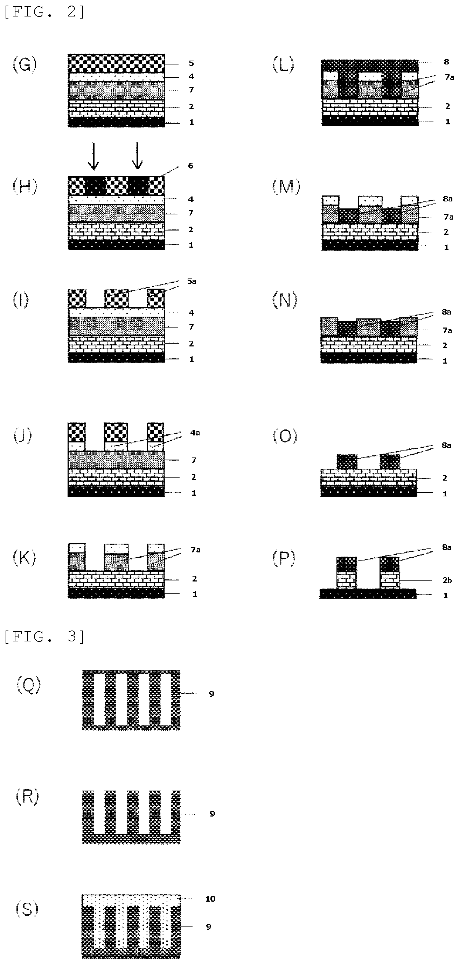

With reference to FIG. 2, a tone-reversal patterning process using a composition for forming a metal-containing film will be described. The present invention provides, as a tone-reversal patterning process using such a composition for forming a metal-containing film, a tone-reversal patterning process including the steps of:
forming a resist underlayer film 7 on a layer 2 to be processed on a substrate 1 to be processed, forming a resist middle layer film 4 or a combination of an inorganic hard mask middle layer film selected from a silicon oxide film, a silicon nitride film, and a silicon oxynitride film and an organic thin film on the resist underlayer film 7, and forming a resist upper layer film 5 on the resist middle layer film 4 or the combination of the inorganic hard mask middle layer film and the organic thin film by using a photoresist material as in FIG. 2(G);
subsequently subjecting an exposure portion 6 of the resist upper layer film to pattern exposure as in FIG. 2(H) and then development with a developer to form a resist upper layer film pattern 5a in the resist upper layer film as in FIG. 2(I);
transferring a resist middle layer film pattern 4a or an inorganic hard mask middle layer film pattern to the resist middle layer film or the organic thin film and the inorganic hard mask middle layer film by dry etching while using the resist upper layer film having the formed pattern as a mask as in FIG. 2(J);
transferring a resist underlayer film pattern 7a to the resist underlayer film by dry etching while using the resist middle layer film or the inorganic hard mask middle layer film having the transferred pattern as a mask as in FIG. 2(K);
covering the resist underlayer film having the formed pattern with a metal-containing film 8 by using the above-described composition for forming a metal-containing film, thereby filling a space between the resist underlayer film patterns 7a with the metal-containing film 8 as in FIG. 2(L);
etching back the metal-containing film covering the resist underlayer film having the formed pattern by a chemical stripper or dry etching to form a reversed metal-containing film pattern 8a to expose an upper surface of the resist underlayer film having the formed pattern as in FIG. 2(M);
removing the resist middle layer film or the hard mask middle layer film remaining on the upper surface of the resist underlayer film pattern 7a by dry etching as in FIG. 2(N);
removing the resist underlayer film having the formed pattern with its surface exposed by dry etching to form a reverse pattern of the original pattern in the metal-containing film as in FIG. 2(O); and
processing the layer to be processed while using the metal-containing film having the formed reverse pattern as a mask to form the reverse pattern 2b in the layer to be processed as in FIG. 2(P).

As described above, when the resist underlayer film is formed on the substrate to be processed, the resist underlayer film can be formed by a method using a coating-type resist underlayer film material, a CVD method, an ALD method, or the like. Examples of the coating-type resist underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal-containing film reverse pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very desirable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type resist underlayer film material.

### EXAMPLE

The present invention is more specifically described below with reference to Synthesis Examples, Comparative Synthesis Examples, Examples, and Comparative Examples. However, the present invention is not limited to these Examples.

### [Synthesis Example]

In the following Synthesis Examples and Comparative Examples, the following organic group starting material group G ((G1) to (G11)) and silicon-containing organic group starting material group H ((H1) to (H5)) were used.

The organic group starting material group G: (G1) to (G11) is shown below.

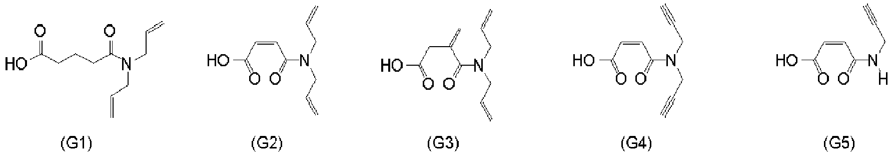

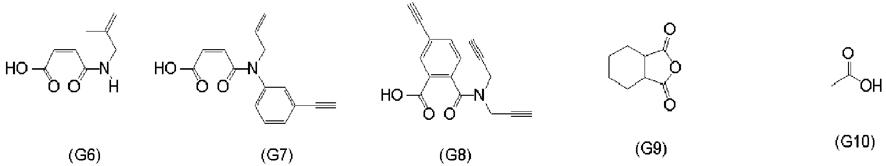

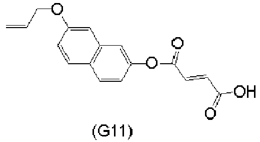

The silicon-containing organic group starting material group H: (H1) to (H5) is shown below.

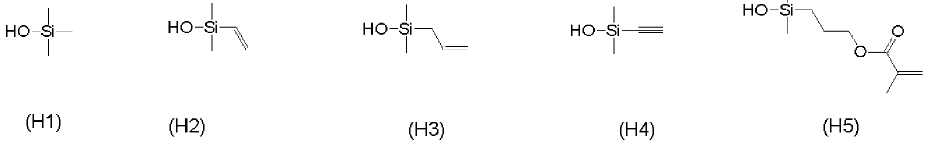

As a metal source M, the following metal compounds were used.
(M1): Zr(OBu)₄: zirconium(IV)tetrabutoxide (80 mass% solution in 1-butanol) (Z0016 manufactured by Tokyo Chemical Industry Co., Ltd.)
(M2): Hf(OBu)₄: hafnium(IV)n-butoxide (667943 manufactured by Sigma-Aldrich Corp)
(M3): Ti(OBu)₄: tetrabutyl orthotitanate (B0742 manufactured by Tokyo Chemical Industry Co., Ltd.)
(M4): titanium butoxide tetramer (FUJIFILM Wako Pure Chemical Corporation)

### [Synthesis Example 1] Synthesis of Compound for Forming Metal-Containing Film (A-1)

Under a nitrogen atmosphere, 15.0 g of zirconium(IV)tetrabutoxide (80 mass% solution in 1-butanol) M1 was dissolved in 20.5 g of a PGMEA/PGME (ratio by weight: 70/30) solution. The reaction temperature was raised to 50°C while stirring, and 7.0 g of the compound H1 was added dropwise to the solution. After the addition, stirring was continued for 2 hours at a reaction temperature of 60°C. Subsequently, a mixture obtained by suspending 12.0 g of the compound G1 in 14.4 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-1) for forming a metal-containing film in PGMEA/PGME was obtained. The concentration of the components in the solution other than the solvent was 20.0 mass%.

Subsequently, thermal mass reduction of (A-1) was measured. As a result, the mass at normal temperature being 100%, the mass was 51% (mass loss: 49%) when the temperature was 350°C due to heating, and 27% (mass loss: 73%) when the temperature was 800°C. In particular, the composition at 800°C was 100% ZrO₂. The Zr content at 350°C calculated from this fact was 27%/51%×91.24/(91.24+16.00×2)=39%.

Accordingly, it was revealed that by thermal decomposition at 350°C, a Zr-containing film having a Zr content of 39% can be obtained.

### [Synthesis of Compounds (A-2) to (A-8) and Compounds (R-1) to (R-3) for Comparative Example]

The compounds (A-2) to (A-8) and comparative compounds (R-1) to (R-3) shown in Tables 1 and 2 were obtained under the same reaction conditions as in Synthesis Example 1, except that the metal source M, the compound group G, and the compound group H were used at the charging amounts shown in Tables 1 and 2.

**[Table 1]**

| Synthesis Example | Metal alkoxide | | Compound group G | | Compound group H | | Compound |
|---|---|---|---|---|---|---|---|
| | Starting material | g | Starting material | g | Starting material | G | |
| 1 | M1 | 15.0 | G1 | 12.0 | H1 | 7.0 | A-1 |
| 2 | M2 | 20.0 | G2 | 13.0 | H2 | 10.0 | A-2 |
| 3 | M3 | 20.0 | G3 | 20.0 | H3 | 13.0 | A-3 |
| 4 | M4 | 10.0 | G4 | 8.0 | H4 | 6.0 | A-4 |
| 5 | M1 | 15.0 | G5 | 15.0 | H5 | 12.0 | A-5 |
| 6 | M1 | 15.0 | G6 | 17.0 | H1 | 4.5 | A-6 |
| 7 | M1 | 9.0 | G7 | 7.0 | H2 | 7.0 | A-7 |
| 8 | M1 | 15.0 | G8 | 12.0 | H2 | 11.0 | A-8 |

**[Table 2]**

| Comparative Synthesis Example | Metal alkoxide | | Compound group G | | Compound group H | | Compound for Comparative Example |
|---|---|---|---|---|---|---|---|
| | Starting material | g | Starting material | g | Starting material | g | |
| 1 | M1 | 13.0 | G9 | 8.6 | H1 | 6.4 | R-1 |
| 2 | M1 | 13.0 | G10 | 3.3 | H2 | 7.3 | R-2 |
| 3 | M1 | 16.5 | G11 | 20.0 | H2 | 10.0 | R-3 |

### [Synthesis of Compound (R-4) for Comparative Example]

A titanium compound reported in [Synthesis Example A-II] of JP6189758B2 was synthesized. An IPA solution (500 g) of deionized water (27 g) was agitated with an IPA solution (500 g) of a titanium tetraisopropoxide (manufactured by Tokyo Chemical Industry Co., Ltd.) (284 g) and dropped at room temperature for 2 hours. 2-methyl-2,4-pentanediol (120 g) was added to a solution obtained and agitated at room temperature for 30 minutes. After the solution was concentrated under reduced pressure at 30°C, it was heated to 60°C and heating was continued under reduced pressure to generate no distillate. Then, PGMEA (1,200 g) was added thereto and heated under reduced pressure at 40°C until no IPA was distilled to obtain a PGMEA solution of a titanium-containing compound (R-4) (1,000 g) (compound concentration: 20 mass%).

### [Synthesis of Resin (R-5) for Forming Organic Film for Comparative Example]

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-5).

The weight-average molecular weight (Mw) and the dispersity (Mw/Mn) were determined by gel permeation chromatography (GPC) using tetrahydrofuran as an eluent, and the following results were obtained.
(R-5): Mw=3,300, Mw/Mn=2.54

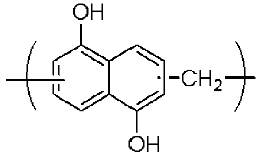

### (Synthesis of Flowability Accelerator)

For the synthesis of flowability accelerators, the following organic group starting material group G ((G12) to (G14)) and modifying agents K ((K1) and (K2)) were used.

The organic group starting material group G: (G12) to (G14) is shown below.

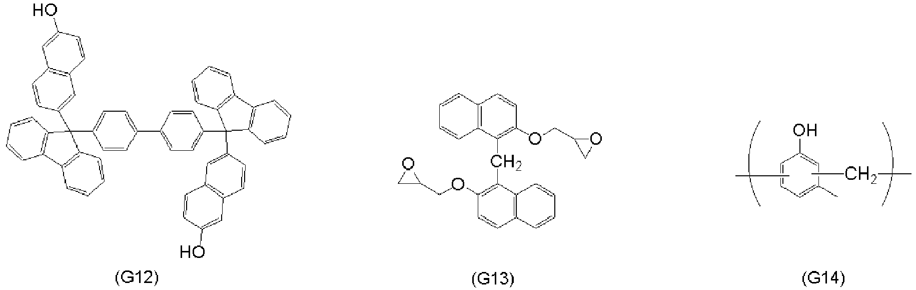

Modifying agents K: (K1) and (K2) are shown below.

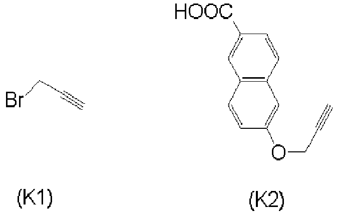

### [Synthesis of Flowability Accelerator (BPA-1)]

Under a nitrogen atmosphere, 45.5 g of the compound (G12) in the organic group starting material group G, 9.8 g of potassium carbonate, and 150 g of DMF were added, and a homogeneous dispersion liquid was prepared at an internal temperature of 50°C. 17.6 g of the modifying agent (K1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a flowability accelerator (BPA-1).

The weight-average molecular weight (Mw) and the dispersity (Mw/Mn) were determined by GPC, and the following results were obtained.
(BPA-1): Mw=965, Mw/Mn=1.08

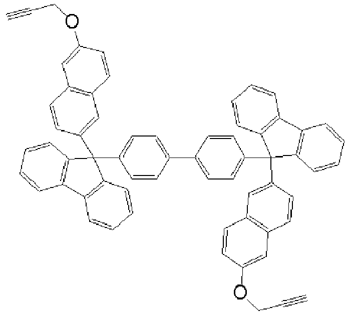

### [Synthesis of Flowability Accelerator (BPA-2)]

Under a nitrogen atmosphere, 80.0 g of the epoxy compound (G13), 51.0 g of the modifying agent (K2), and 600 g of 2-methoxy-1-propanol were mixed to yield a homogeneous solution at an internal temperature of 100°C, and then 5.7 g of benzyltriethylammonium chloride was added thereto, followed by stirring at an internal temperature of 120°C for 12 hours. After cooling to room temperature, 1,500 g of methylisobutylketone was added and the organic layer was washed with 300 g of pure water five times. The organic layer was solidified under reduced pressure, thereby obtaining a flowability accelerator (BPA-2).

The weight-average molecular weight (Mw) and the dispersity (Mw/Mn) were determined by GPC, and the following results were obtained.
(BPA-2): Mw=900, Mw/Mn=1.04

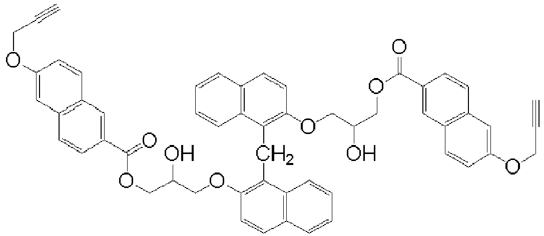

### [Synthesis of Flowability Accelerator (BPA-3)]

Under a nitrogen atmosphere, 20.0 g of the resin (G14), 34.5 g of potassium carbonate, and 100 g of DMF were added, and a homogeneous dispersion liquid was prepared at an internal temperature of 50°C. 23.8 g of the modifying agent (K1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a flowability accelerator (BPA-3).

The weight-average molecular weight (Mw) and the dispersity (Mw/Mn) were determined by GPC, and the following results were obtained.
(BPA-3): Mw=9,400, Mw/Mn=3.59

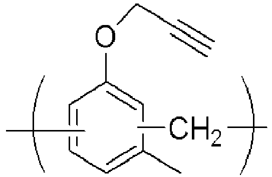

### [Preparation of Composition (UDL-1) for Forming Metal-Containing Film]

The compound (A-1) for forming a metal-containing film was dissolved at a ratio shown in Table 3 in a mixed solvent of propylene glycol monomethyl ether acetate (PGMEA) and propylene glycol monomethyl ether (PGME) containing 0.5 mass% of a surfactant FC-4430 (manufactured by Sumitomo 3M Limited), and the solution was filtered through a 0.02-µm membrane filter to prepare a composition (UDL-1) for forming a metal-containing film.

### [Preparation of Compositions (UDL-2 to -15) for Forming Metal-Containing Film and Compositions (Comparative UDL-1 to -5) for Forming Metal-Containing Film for Comparative Examples]

Each chemical solution was prepared in the same manner as UDL-1, except that the type and the contained amount of each component were as shown in Table 3. In Table 3, "-" indicates that the component was not used. The following formula (C-1) was used for the crosslinking agent, the following formula (F-1) was used for the acid generator (TAG), ethylene glycol dibenzyl ether (boiling point: 364°C) was used as the high-boiling-point solvent (B-1), and ZrO₂ nanoparticles (5 nm core, 915505, manufactured by Sigma-Aldrich Corp) were used as metal nanoparticles (G-1).

### [Crosslinking Agent and Acid Generator]

The crosslinking agent (C-1) and the acid generator (F-1) used in a composition for forming a metal-containing film are shown below.

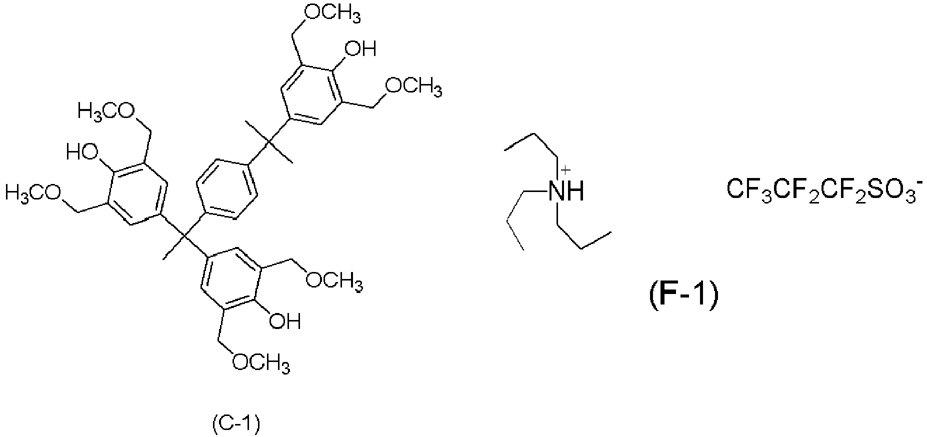

**[Table 3]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (10) | - | PGMEA/PGME (60/30) |
| UDL-2 | A-2 (10) | - | PGMEA/PGME (60/30) |
| UDL-3 | A-3 (10) | - | PGMEA/PGME (60/30) |
| UDL-4 | A-4 (10) | - | PGMEA/PGME (60/30) |
| UDL-5 | A-5 (10) | - | PGMEA/PGME (60/30) |
| UDL-6 | A-6 (10) | - | PGMEA/PGME (60/30) |
| UDL-7 | A-7 (10) | - | PGMEA/PGME (60/30) |
| UDL-8 | A-8 (10) | - | PGMEA/PGME (60/30) |
| UDL-9 | A-1 (10) | F-1 (0.2) | PGMEA/PGME (60/30) |
| UDL-10 | A-2 (10) | C-1 (2) | PGMEA/PGME (60/30) |
| UDL-11 | A-3 (10) | G-1 (2) | PGMEA/PGME (60/30) |
| UDL-12 | A-4 (10) | B-1 (5) | PGMEA/PGME (60/30) |
| UDL-13 | A-5 (10) | BPA-1 (1) | PGMEA/PGME (60/30) |
| UDL-14 | A-6 (10) | BPA-2 (1) | PGMEA/PGME (60/30) |
| UDL-15 | A-7 (10) | BPA-3 (1) | PGMEA/PGME (60/30) |
| Comparative UDL-1 | R-1 (10) | - | PGMEA/PGME (60/30) |
| Comparative UDL-2 | R-2 (10) | - | PGMEA/PGME (60/30) |
| Comparative UDL-3 | R-3 (10) | - | PGMEA/PGME (60/30) |
| Comparative UDL-4 | R-4 (10) | - | PGMEA (90) |
| Comparative UDL-5 | R-5 (5) | - | PGMEA (95) |

### [Filling Property Evaluation (Examples 1-1 to 1-15 and Comparative Examples 1-1 to 1-4)]

Each of the compositions (UDL-1 to -15 and comparative UDL-1 to -4) prepared above was respectively applied onto an SiO₂ wafer substrate having a dense line-and-space pattern (line width = 60 nm, line depth = 100 nm, distance between the centers of two adjacent lines, 120 nm), followed by heating by using a hot plate at 350°C for 60 seconds to form a metal-containing film having a film thickness of 80 nm (filling evaluation B). The substrate used was a base substrate 9 (SiO₂ wafer substrate) having a dense line-and-space pattern shown in FIG. 3(Q) (downward view) and (R) (cross-sectional view). In the filling evaluation B, the cross-sectional shape of each of the obtained wafer substrates was observed using an electron microscope (S-4700: manufactured by Hitachi, Ltd.), and the presence/absence of voids (gaps) inside the metal-containing film filling the space between the lines was confirmed. Table 4 shows the results. In this evaluation, when a composition for forming a metal-containing film having a poor filling property is used, voids are generated inside the metal-containing film filling the space between the lines. In this evaluation, when a composition for forming a metal-containing film having a desirable filling property is used, as shown in FIG. 3(S), the inside of the metal-containing film filling the space between the lines of the base substrate 9 having the dense line-and-space pattern is filled with a void-free metal-containing film 10.

**[Table 4]**

| Example | Composition for forming metal-containing film | 350°C |
|---|---|---|
| | | Voids |
| Example 1-1 | UDL-1 | Absent |
| Example 1-2 | UDL-2 | Absent |
| Example 1-3 | UDL-3 | Absent |
| Example 1-4 | UDL-4 | Absent |
| Example 1-5 | UDL-5 | Absent |
| Example 1-6 | UDL-6 | Absent |
| Example 1-7 | UDL-7 | Absent |
| Example 1-8 | UDL-8 | Absent |
| Example 1-9 | UDL-9 | Absent |
| Example 1-10 | UDL-10 | Absent |
| Example 1-11 | UDL-11 | Absent |
| Example 1-12 | UDL-12 | Absent |
| Example 1-13 | UDL-13 | Absent |
| Example 1-14 | UDL-14 | Absent |
| Example 1-15 | UDL-15 | Absent |
| Comparative Example 1-1 | Comparative UDL-1 | Present |
| Comparative Example 1-2 | Comparative UDL-2 | Present |
| Comparative Example 1-3 | Comparative UDL-3 | Absent |
| Comparative Example 1-4 | Comparative UDL-4 | Present |

It was successfully confirmed that, as shown in Table 4, in Examples 1-1 to 1-15 using the inventive compositions (UDL-1 to -15) for forming a metal-containing film, it was possible to fill the dense line-and-space pattern without the generation of voids even after baking at 350°C, and excellent filling property was provided even under high-temperature baking conditions. On the other hand, voids were observed at the bottom of the pattern after baking at 350°C in the case of comparative UDL-1, -2, and -4, where an organic group including no crosslinking groups was coordinated in the metal compound used unlike the inventive compound for forming a metal-containing film. It is conjectured that voids were generated since volume shrinkage due to high-temperature baking was great because, in the case of comparative UDL-1, the compound had no crosslinking group structure, and in the case of comparative UDL-2 and -4, the organic ligand had low heat resistance. Meanwhile, regarding comparative UDL-3, it is conjectured that volume shrinkage during high-temperature baking was small and good filling property was exhibited because the compound had an organic ligand including a crosslinking group on an end.

### [Planarizing Property Evaluation (Examples 2-1 to 2-15 and Comparative Examples 2-1 and 2-2)]

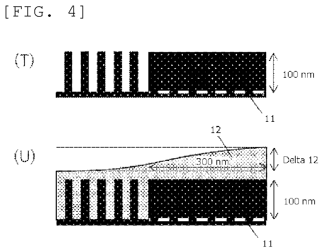

Regarding base substrates 11 (SiO₂ wafer substrates) each having a dense line-and-space pattern as shown in FIG. 4(T), the cross sectional shape of each of the wafer substrates in which no voids were observed in the filling property evaluation after baking at 350°C as shown in FIG. 4(U) was observed using a scanning electron microscope (SEM), and the step (Delta 12 in FIG. 4(U)) between the line-pattern-dense portion and the non-line-pattern portion of the filling film 12 was observed using an electron microscope (S-4700: manufactured by Hitachi, Ltd.). Table 5 shows the results. In the present evaluation, it can be said that the smaller the step, the better the planarizing property.

**[Table 5]**

| Example | Composition for forming metal-containing film | Flatness |
|---|---|---|
| | | nm |
| Example 2-1 | UDL-1 | 31 |
| Example 2-2 | UDL-2 | 29 |
| Example 2-3 | UDL-3 | 29 |
| Example 2-4 | UDL-4 | 28 |
| Example 2-5 | UDL-5 | 29 |
| Example 2-6 | UDL-6 | 30 |
| Example 2-7 | UDL-7 | 33 |
| Example 2-8 | UDL-8 | 34 |
| Example 2-9 | UDL-9 | 31 |
| Example 2-10 | UDL-10 | 28 |
| Example 2-11 | UDL-11 | 27 |
| Example 2-12 | UDL-12 | 26 |
| Example 2-13 | UDL-13 | 27 |
| Example 2-14 | UDL-14 | 28 |
| Example 2-15 | UDL-15 | 29 |
| Comparative Example 2-1 | Comparative UDL-3 | 28 |
| Comparative Example 2-2 | Comparative UDL-5 | 49 |

As shown in Table 5, it was shown that the step in the film between the patterned portion and the nonpatterned portion was smaller in Examples 2-1 to 2-15, where the inventive compositions (UDL-1 to -15) for forming a metal-containing film were used, than in Comparative Example 2-2, where an organic resist underlayer film material was used, and the planarizing property of the inventive compositions compared favorably with that of the organic resist underlayer film. Meanwhile, UDL-12, containing the high-boiling-point solvent (B-1), and UDL-13 to -15, containing the flowability accelerators (BPA-1 to -3), showed better planarizing property. It is conjectured that the thermal flowability of the compositions for forming a metal-containing film was successfully further enhanced by the use of the additives. In addition, it was found that comparative UDL-3, which had a crosslinking group different from the crosslinking group of the inventive compound for forming a metal-containing film, showed good flatness.

### [Etching Resistance Evaluation (Examples 3-1 to 3-15 and Comparative Examples 3-1 and 3-2)]

Each of the compositions (UDL-1 to -15, comparative UDL-3, and comparative UDL-5), in which no voids were observed in the filling evaluation after baking at 350°C, for forming a metal-containing film was respectively applied onto a silicon substrate and heated by using a hot plate at 350°C for 60 seconds to form a metal-containing film having a film thickness of 80 nm, and the film thickness "a" was measured. Subsequently, etching was performed with CF₄ gas and Cl₂ gas under the following conditions by using an etching apparatus CE-300I manufactured by ULVAC, Inc., and the film thickness "b" was measured. Then, the film thickness etched in 1 minute was calculated as an etching rate (nm/min) from the film thickness etched (film thickness "b" - film thickness "a") by each gas in a specified time. Table 6 shows the results.

### Conditions of dry etching with CF₄ gas

Pressure: 1 Pa
Antenna RF power: 100 W
Bias RF power: 15 W
CF₄ gas flow rate: 30 sccm
Time: 30 sec

### Conditions of dry etching with Cl₂ gas

Pressure: 1 Pa
Antenna RF power: 320 W
Bias RF power: 30 W
Cl₂ gas flow rate: 30 sccm
Time: 20 sec

**[Table 6]**

| Example | Composition for forming metal-containing film | Etching speed (nm/min) | Etching speed (nm/min) |
|---|---|---|---|
| | | CF₄ | Cl₂ |
| Example 3-1 | UDL-1 | 33 | 123 |
| Example 3-2 | UDL-2 | 31 | 122 |
| Example 3-3 | UDL-3 | 31 | 121 |
| Example 3-4 | UDL-4 | 30 | 122 |
| Example 3-5 | UDL-5 | 36 | 127 |
| Example 3-6 | UDL-6 | 37 | 128 |
| Example 3-7 | UDL-7 | 29 | 124 |
| Example 3-8 | UDL-8 | 32 | 125 |
| Example 3-9 | UDL-9 | 33 | 123 |
| Example 3-10 | UDL-10 | 30 | 120 |
| Example 3-11 | UDL-11 | 29 | 135 |
| Example 3-12 | UDL-12 | 30 | 122 |
| Example 3-13 | UDL-13 | 39 | 134 |
| Example 3-14 | UDL-14 | 40 | 137 |
| Example 3-15 | UDL-15 | 35 | 136 |
| Comparative Example 3-1 | Comparative UDL-3 | 45 | 155 |
| Comparative Example 3-2 | Comparative UDL-5 | 72 | 195 |

As shown in Table 6, it was shown that considerably better etching resistance to CF₄ gas was exhibited in Examples 3-1 to 3-15, where the inventive compositions (UDL-1 to -15) for forming a metal-containing film were used, than in Comparative Example 3-2, where an organic resist underlayer film material was used. It was also shown that the inventive compositions also exhibited better etching resistance to CF₄ gas compared to comparative UDL-3, which contained a compound for forming a metal-containing film having no organic groups represented by the general formula (1) of the present invention.

In order to improve filling property, the introduction of a crosslinkable organic group is necessary. However, it can be assumed that if the structure of the organic group is large, the amount of organic components in the cured film becomes large and leads to the degradation of dry etching resistance. On the other hand, in the inventive compound for forming a metal-containing film, the structure of the crosslinkable organic group is small, and the amount of organic components in the cured film can be reduced. It is conjectured that the degradation of dry etching resistance was thus successfully suppressed.

Meanwhile, it was revealed that the inventive compositions for forming a metal-containing film exhibited better removability by etching using Cl₂ gas than CF₄ gas.

### [Patterning Process (Examples 4-1 to 4-15 and Comparative Examples 4-1 to 4-4)]

Each of the compositions (UDL-1 to -15 and comparative UDL-1, -2, -4, and -5) for forming a metal-containing film was respectively applied onto an SiO₂ wafer substrate having a trench pattern (trench width: 10 um, trench depth: 0.10 pm), and baked at 350°C for 60 seconds in the atmosphere to form a metal-containing film having a thickness of 70 nm. A silicon-containing resist middle layer film material (SOG-1) was applied thereto, followed by baking at 220°C for 60 seconds to form a resist middle layer film having a thickness of 50 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 7; and filtering the solution through a filter made of a fluororesin and having a pore size of 0.1 µm.

**[Table 7]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4, 000) |

The structural formulae of the used ArF silicon-containing middle layer film polymer (SiP1) and thermal crosslinking catalyst (CAT1) are shown below.

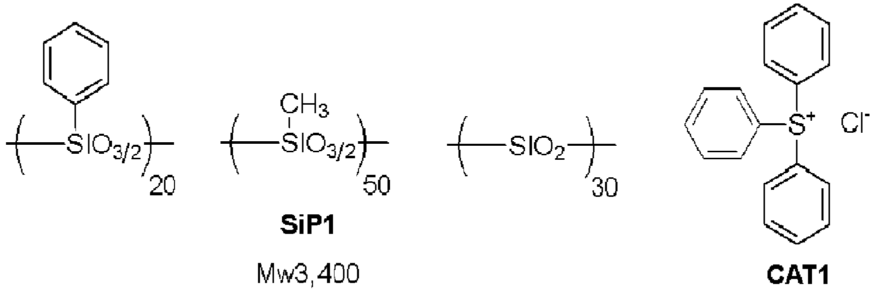

The resist upper layer film material (monolayer resist for ArF) was prepared by dissolving a polymer (RP1), an acid generator (PAG1), and a basic compound (Amine1), each in the proportion shown in Table 8, in a solvent containing 0.1% by mass of a surfactant (FC-4430: manufactured by Sumitomo 3M Limited), and filtering the solution through a 0.1-pm filter made of a fluororesin.

**[Table 8]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

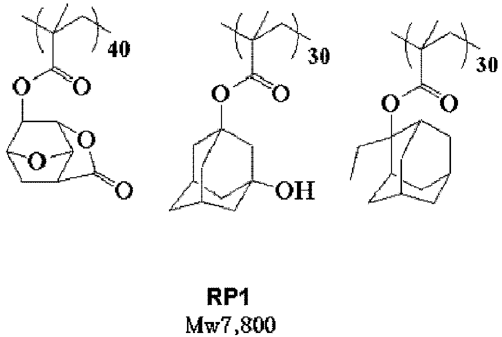

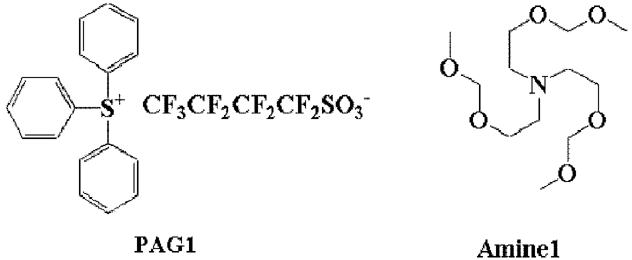

The liquid immersion top coat composition (TC-1) was prepared by dissolving a top coat polymer (PP1) in an organic solvent at the proportion shown in Table 9, and filtering the solution through a 0.1-pm filter made of a fluororesin.

**[Table 9]**

| | Top coat polymer (parts by mass) | Organic solvent (parts by mass) |
|---|---|---|
| TC-1 | PP1 | Diisoamyl ether (2,700) |
| | (100) | 2-methyl-1-butanol (270) |

The top coat polymer (PP1) used for the liquid immersion top coat composition (TC-1) is shown below.

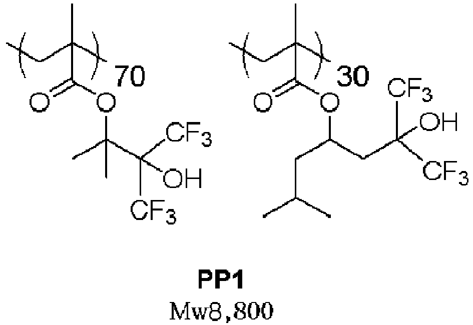

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching while using the resist upper layer film pattern as a mask to form a hard mask pattern. A metal-containing film was then etched while using the obtained hard mask pattern as a mask to form a metal-containing film pattern, and the SiO₂ film was etched while using the obtained metal-containing film pattern as a mask. The etching conditions were as follows.

### Conditions in transferring resist upper layer film pattern to resist middle layer film

### Conditions of dry etching with CF₄ gas

Pressure: 1 Pa
Antenna RF power: 100 W
Bias RF power: 15 W
CF₄ gas flow rate: 15 sccm
Time: 60 sec

### Conditions in transferring hard mask pattern to metal-containing film

### Conditions of dry etching with Cl₂ gas

Pressure: 1 Pa
Antenna RF power: 320 W
Bias RF power: 30 W
Cl₂ gas flow rate: 25 sccm
Time: 45 sec

### Conditions in transferring metal-containing film pattern to SiO₂ film

### Conditions of dry etching with CF₄ gas

Pressure: 1 Pa
Antenna RF power: 100 W
Bias RF power: 15 W
CF₄ gas flow rate: 15 sccm
Time: 60 sec

Table 10 shows the results obtained by observation of the pattern cross section with an electron microscope (S-4700) manufactured by Hitachi, Ltd.

**[Table 10]**

| Example | Composition for forming metal-containing film | Pattern profile after etching for transferring to substrate |
|---|---|---|
| Example 4-1 | UDL-1 | Vertical profile |
| Example 4-2 | UDL-2 | Vertical profile |
| Example 4-3 | UDL-3 | Vertical profile |
| Example 4-4 | UDL-4 | Vertical profile |
| Example 4-5 | UDL-5 | Vertical profile |
| Example 4-6 | UDL-6 | Vertical profile |
| Example 4-7 | UDL-7 | Vertical profile |
| Example 4-8 | UDL-8 | Vertical profile |
| Example 4-9 | UDL-9 | Vertical profile |
| Example 4-10 | UDL-10 | Vertical profile |
| Example 4-11 | UDL-11 | Vertical profile |
| Example 4-12 | UDL-12 | Vertical profile |
| Example 4-13 | UDL-13 | Vertical profile |
| Example 4-14 | UDL-14 | Vertical profile |
| Example 4-15 | UDL-15 | Vertical profile |
| Comparative Example 4-1 | Comparative UDL-1 | Pattern collapse |
| Comparative Example 4-2 | Comparative UDL-2 | Pattern collapse |
| Comparative Example 4-3 | Comparative UDL-4 | Pattern collapse |
| Comparative Example 4-4 | Comparative UDL-5 | Distorted pattern |

As shown in Table 10, in Examples 4-1 to 4-15, where the inventive compositions (UDL-1 to -15) for forming a metal-containing film were used, the resist upper layer film pattern was successfully transferred to the substrate in the end in every case. Thus, it was confirmed that the inventive composition for forming a metal-containing film can be used suitably for fine processing using a multilayer resist method. On the other hand, in Comparative Examples 4-1 to 4-3, where the performance in the filling property evaluation was found to be insufficient, pattern collapse occurred during patterning, and it was not possible to obtain a favorable pattern in the end. Meanwhile, in Comparative Example 4-4, where insufficient performance was observed in the dry etching resistance evaluation, distortion of the pattern profile occurred at the time of pattern processing, and it was not possible to obtain a favorable pattern in the end.

### [SOC Pattern Inversion Method (Examples 5-1 to 5-15 and Comparative Examples 5-1 to 5-5)]

The coating-type resist underlayer film composition (SOC-1) was applied as a resist underlayer film onto a silicon wafer substrate on which an SiO₂ film having a thickness of 300 nm was formed, and the substrate was then baked at 350°C for 60 seconds to form a resist underlayer film having a thickness of 80 nm. A silicon atom-containing resist middle layer film composition (SOG-1) was applied thereto, followed by baking at 220°C for 60 seconds to form a resist middle layer film having a thickness of 40 nm. Then, a monolayer resist for ArF as a resist upper layer film composition was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon atom-containing resist middle layer film composition (SOG-1), the resist upper layer film composition (monolayer resist for ArF), and the liquid immersion top coat composition (TC-1) on the photoresist film were made of the same composition as that used in the patterning process (Example 4).

The coating-type resist underlayer film composition (SOC-1) was prepared by dissolving the polymer denoted by the resist underlayer film polymer (SOP1) in an organic solvent containing 0.1% by mass of FC-4430 (manufactured by Sumitomo 3M Limited) at the proportions shown in Table 11 and filtering the resulting solution through a filter made of a fluororesin having a pore size of 0.2 µm.

**[Table 11]**

| | Polymer for resist underlayer film | Organic solvent |
|---|---|---|
| | (parts by mass) | (parts by mass) |
| SOC-1 | SOP1 (5) | Propylene glycol monoethyl ether (95) |

The structural formula of the resist underlayer film polymer (SOP1) used herein is shown in Table 12.

**[Table 12]**

| Compound or polymer | Mw | Mw/Mn |
|---|---|---|
| 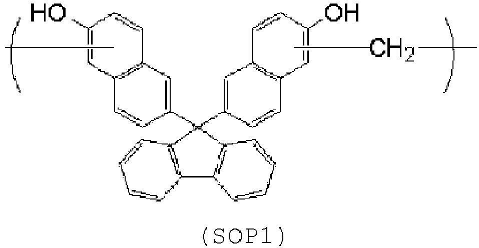 | 3,700 | 2.82 |

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass of aqueous tetramethylammonium hydroxide (TMAH) solution for 30 seconds, thereby obtaining a 55 nm 1:1 positive line-and-space pattern (resist upper layer film pattern).

Then, the resist middle layer film was etched by dry etching while using the resist upper layer film pattern as a mask using an etching apparatus Telius manufactured by Tokyo Electron Ltd. to form a hard mask pattern. Then, a resist underlayer film (SOC-1) was etched while using the obtained hard mask pattern as a mask to form a SOC-1 film pattern. The etching conditions were as follows.

### Conditions in transferring resist upper layer film pattern to resist middle layer film

Chamber pressure: 50 mT
RF-power (upper portion): 500 W
RF-power (lower portion): 300 W
CF₄ gas flow rate: 150 sccm
CHF₃ gas flow rate: 50 sccm
Time: 20 sec

### Conditions in transferring hard mask pattern to SOC-1 film

Chamber pressure: 10 mT
RF-power (upper portion): 1,000 W
RF-power (lower portion): 300 W
CO₂ gas flow rate: 150 sccm
CO gas flow rate: 50 sccm
N₂ gas flow rate: 50 sccm
H₂ gas flow rate: 150 sccm
Time: 60 sec

Next, the compositions (UDL-1 to -15, comparative UDL-1 and -2, and comparative -4 and -5) for forming a metal-containing film were each applied respectively onto the obtained SOC-1 film pattern, followed by baking in the atmosphere at 350°C for 60 seconds to form a metal-containing film having a thickness of 80 nm. Thereafter, the metal-containing film covering the SOC-1 film pattern was etched to expose the upper surface of the SOC-1 film pattern. The resist middle layer film remaining on the surface of the SOC-1 film pattern with the exposed upper surface was removed by etching, then the exposed SOC-1 film pattern was removed by etching, the above pattern was inverted onto a metal-containing film, and the SiO₂ film was etched while using the obtained metal-containing film pattern as a mask. As a Comparative Example, etching of the SiO₂ film was performed while using the SOC-1 film pattern as a mask without using the composition for forming a metal-containing film (Comparative Example 5-5). The etching conditions were as follows.

### Conditions in etch-back of metal-containing film (exposure of SOC-1 film pattern)

Pressure: 1 Pa
Antenna RF power: 320 W
Bias RF power: 30 W
Cl₂ gas flow rate: 25 sccm
Time: 15 sec

### Removal of resist middle layer film remaining on SOC-1 film pattern

### Conditions of dry etching with CF₄ gas

Pressure: 1 Pa
Antenna RF power: 100 W
Bias RF power: 15 W
CF₄ gas flow rate: 15 sccm
Time: 45 sec

### Removal of SOC-1 film pattern

### Conditions of dry etching with O₂ gas

Pressure: 1 Pa
Antenna RF power: 300 W
Bias RF power: 0 W
O₂ gas flow rate: 25 sccm
Time: 30 sec

### Conditions in transferring metal-containing film pattern to SiO₂ film

### Conditions of dry etching with CF₄ gas

Pressure: 1 Pa
Antenna RF power: 100 W
Bias RF power: 15 W
CF₄ gas flow rate: 15 sccm
Time: 60 sec

### Comparative Example 5-5: conditions in transferring SOC-1 film pattern to SiO₂ film

### Conditions of dry etching with CF₄ gas

Pressure: 1 Pa
Antenna RF power: 100 W
Bias RF power: 15 W
CF₄ gas flow rate: 15 sccm
Time: 60 sec

Table 13 shows the results obtained by observation of the pattern cross section with an electron microscope (S-4700) manufactured by Hitachi, Ltd.

**[Table 13]**

| Example | Composition for forming metal-containing film | Pattern profile after SOC pattern inversion |
|---|---|---|
| Example 5-1 | UDL-1 | Vertical profile |
| Example 5-2 | UDL-2 | Vertical profile |
| Example 5-3 | UDL-3 | Vertical profile |
| Example 5-4 | UDL-4 | Vertical profile |
| Example 5-5 | UDL-5 | Vertical profile |
| Example 5-6 | UDL-6 | Vertical profile |
| Example 5-7 | UDL-7 | Vertical profile |
| Example 5-8 | UDL-8 | Vertical profile |
| Example 5-9 | UDL-9 | Vertical profile |
| Example 5-10 | UDL-10 | Vertical profile |
| Example 5-11 | UDL-11 | Vertical profile |
| Example 5-12 | UDL-12 | Vertical profile |
| Example 5-13 | UDL-13 | Vertical profile |
| Example 5-14 | UDL-14 | Vertical profile |
| Example 5-15 | UDL-15 | Vertical profile |
| Comparative Example 5-1 | Comparative UDL-1 | Pattern collapse |
| Comparative Example 5-2 | Comparative UDL-2 | Pattern collapse |
| Comparative Example 5-3 | Comparative UDL-4 | Pattern collapse |
| Comparative Example 5-4 | Comparative UDL-5 | Distorted pattern |
| Comparative Example 5-5 | None | Distorted pattern |

As shown in Table 13, Examples 5-1 to 5-15 using the inventive compositions (UDL-1 to -15) for forming a metal-containing film were all capable of accurately inverting the SOC-1 film pattern, and the reverse pattern was desirably transferred to the substrate in the end without pattern collapse. It was thus confirmed that the inventive composition for forming a metal-containing film can be suitably used for fine processing using the tone-reversal etching method of the multilayer resist process method. On the other hand, in Comparative Example 5-5, in which the SOC-1 film pattern was directly transferred to the SiO₂ film, the etching resistance of the SOC-1 film was insufficient, and therefore, the distortion of the pattern shape was observed. Further, in Comparative Examples 5-1 to 5-3, in which insufficient performance was observed in the evaluation of filling property, pattern collapse occurred at the time of pattern processing, and a desirable reverse pattern could not be obtained in the end. Meanwhile, in Comparative Example 5-4, in which the performance was found insufficient in the evaluation of the dry etching resistance, distortion of the pattern shape occurred at the time of pattern inversion processing, and a desirable reverse pattern could not be obtained in the end.

It was thus revealed that a composition for forming a metal-containing film containing the inventive compound for forming a metal-containing film has both high filling/planarizing properties and dry etching resistance, and therefore, is significantly useful as a resist underlayer film composition used in the multilayer resist method and as an inverting agent used in the tone-reversal etching method, and that the inventive patterning process using this composition is capable of forming fine patterns with a high degree of accuracy even when a body to be processed is a substrate having a step.

The present description includes the following embodiments.
[1]: A compound for forming a metal-containing film to be contained in a composition for forming a metal-containing film, wherein the compound is a metal compound comprising at least one kind of metal atom selected from the group consisting of Ti, Zr, and Hf and a ligand coordinated to the metal atom, and the ligand includes a crosslinking group represented by one of the following general formulae (W-1), 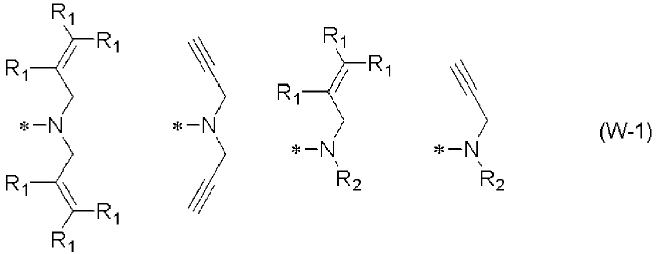 wherein R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.
[2]: The compound for forming a metal-containing film of the above [1], wherein the compound is represented by the following general formula (A), 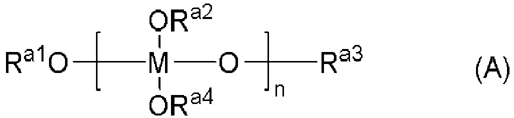 wherein M represents Ti, Zr, or Hf; R^{a1}, R^{a2}, R^{a3}, and R^{a4} each represent an organic group represented by the following general formula (1), a silicon-containing organic group represented by the following general formula (2), or an alkyl group having 1 to 10 carbon atoms, at least one of R^{a1}, R^{a2}, R^{a3}, and R^{a4} being an organic group represented by the following general formula (1) and at least one of R^{a1}, R^{a2}, R^{a3}, and R^{a4} being a silicon-containing organic group represented by the following general formula (2); and "n" represents 1 to 30, 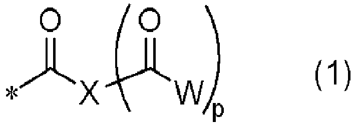 wherein X represents an organic group having 1 to 31 carbon atoms and having a valency of p+1; W represents any structure represented by one of the general formulae (W-1); "p" represents 1 to 4; and "*" represents an attachment point to an oxygen atom, 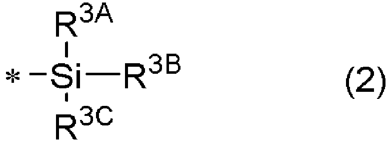 wherein R^{3A}, R^{3B}, and R^{3C} each represent any organic group selected from an organic group having 2 to 30 carbon atoms and having a crosslinking group of any structure represented by one of the following general formulae (c-1) to (c-3), a substituted or unsubstituted alkyl group having 1 to 20 carbon atoms, and an aryl group having 6 to 20 carbon atoms; and "*" represents an attachment point to an oxygen atom, 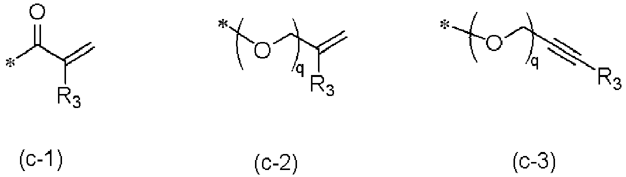 wherein R₃ represents a hydrogen atom or a monovalent organic group having 1 to 10 carbon atoms; "q" represents 0 or 1; and "*" represents an attachment point.
[3]: The compound for forming a metal-containing film of the above [2], wherein the X in the general formula (1) represents a saturated hydrocarbon group having 1 to 20 carbon atoms or an unsaturated hydrocarbon group having 2 to 20 carbon atoms.
[4]: The compound for forming a metal-containing film of the above [3], wherein the X in the general formula (1) represents one of the following general formulae (3), 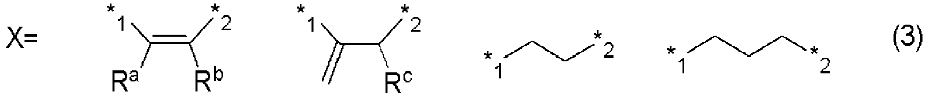 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.
[5]: The compound for forming a metal-containing film of any one of the above [2] to [4], wherein the silicon-containing organic group has a structure represented by one of the following general formulae (2A), 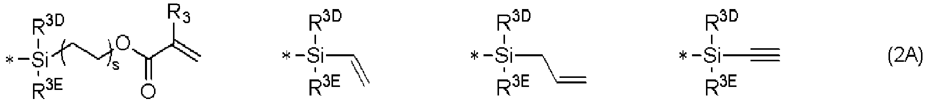 wherein R^{3D} and R^{3E} each represent an organic group selected from a substituted or unsubstituted alkyl group having 1 to 20 carbon atoms and an aryl group having 6 to 20 carbon atoms; R₃ is as defined above; "s" represents 1 to 10; and "*" represents an attachment point to an oxygen atom.
[6]: A composition for forming a metal-containing film comprising: (A) the compound for forming a metal-containing film of any one of the above [1] to [5]; and (B) an organic solvent.
[7]: The composition for forming a metal-containing film of the above [6], further comprising one or more of (C) a crosslinking agent, (E) a surfactant, and (F) an acid generator.
[8]: The composition for forming a metal-containing film of the above [6] or [7], wherein the organic solvent (B) contains, as (B1) a high-boiling-point solvent, one or more kinds of organic solvent having a boiling point of 180°C or higher.
[9]: The composition for forming a metal-containing film of any one of the above [6] to [8], further comprising (G) metal oxide nanoparticles having an average primary particle size of 100 nm or less.
[10]: The composition for forming a metal-containing film of the above [9], wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.
[11]: The composition for forming a metal-containing film of any one of the above [6] to [10], further comprising (BP) a flowability accelerator having any organic group represented by the following general formulae (3') and an aromatic ring, 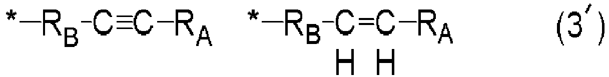 wherein "*" represents an attachment point to an oxygen atom; R_{B} represents a divalent organic group having 1 to 10 carbon atoms; and R_{A} represents a hydrogen atom or a monovalent organic group having 1 to 10 carbon atoms.
[12]: The composition for forming a metal-containing film of the above [11], wherein the flowability accelerator (BP) has at least one constitutional unit represented by the following general formulae (BP-1), (BP-2), (BP-3), (BP-4), and (BP-5), 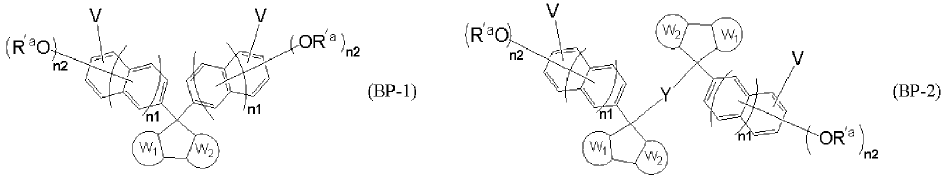 wherein W₁ and W₂ each independently represent a benzene ring or a naphthalene ring, part of hydrogen atoms in the benzene ring and the naphthalene ring optionally being substituted with a hydrocarbon group having 1 to 6 carbon atoms; each R'^{a} independently represents either group represented by the following formulae (4); Y represents any group represented by the following formulae (5); each "n₁" independently represents 0 or 1; each "n₂" independently represents 1 or 2; and each V independently represents a hydrogen atom or an attachment point, 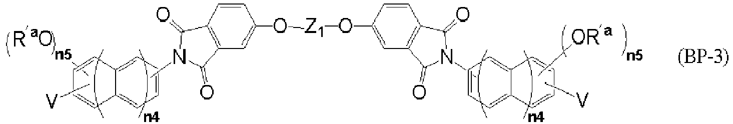 wherein Z₁ represents any group represented by the following general formulae (6); each R'^{a} independently represents either group represented by the following formulae (4); each "n₄" independently represents 0 or 1; each "n₅" independently represents 1 or 2; and each V independently represents a hydrogen atom or an attachment point, 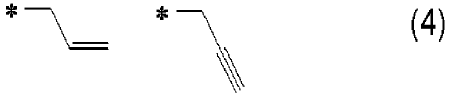 wherein "*" represents an attachment point to an oxygen atom, 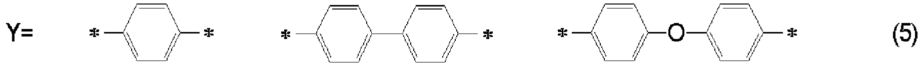 wherein "*" represents an attachment point, 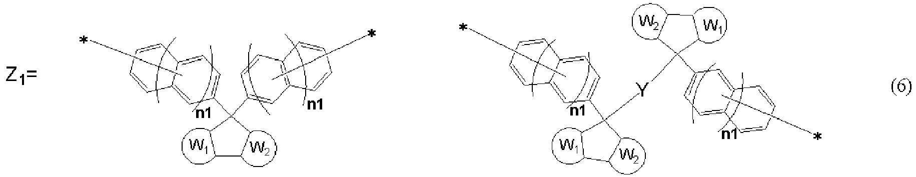 wherein W₁, W₂, Y, and "n₁" are as defined above; and "*" represents an attachment point, 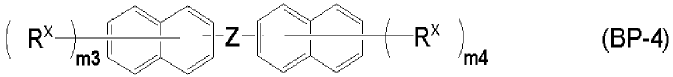 wherein "m₃" and "m₄" each independently represent 1 or 2; Z represents a single bond or any structure represented by the following general formulae (7); and each R^{x} independently represents any structure represented by the following general formulae (8), 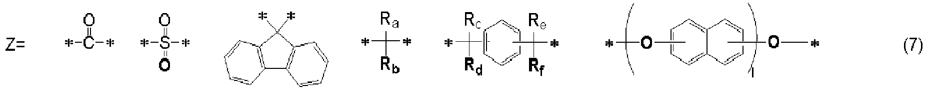 wherein "*" represents an attachment point; "l" represents an integer of 0 to 3; Rₐ to R_{f} each independently represent a hydrogen atom, an alkyl group having 1 to 10 carbon atoms and optionally having a substituent fluorine atom, a phenyl group, or a phenylethyl group, Rₐ and R_{b} optionally being bonded to each other to form a cyclic compound, 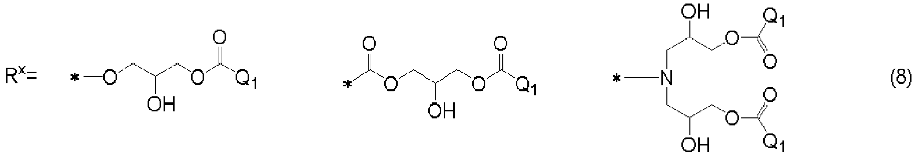 wherein "*" represents an attachment point to an aromatic ring; and Q₁ represents a linear saturated hydrocarbon group having 1 to 30 carbon atoms or a structure represented by the following general formula (9), 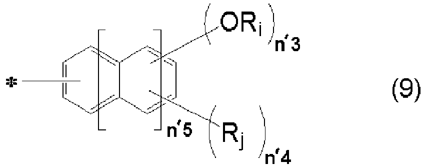 wherein "*" represents an attachment point to a carbonyl group; Rᵢ represents either group represented by the formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n'₃" and "n'₄" each represent a number of substituents on an aromatic ring, the number each representing an integer of 0 to 7, provided that n'₃+n'₄ is 0 or more and 7 or less; and "n'₅" represents 0 to 2, 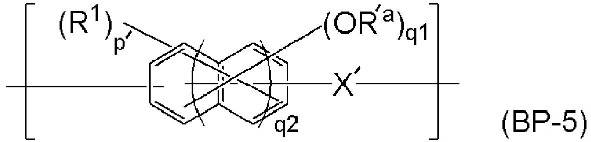 wherein R¹ represents a saturated monovalent organic group having 1 to 30 carbon atoms or an unsaturated monovalent organic group having 2 to 30 carbon atoms; X' represents a divalent organic group having 1 to 30 carbon atoms; R'^{a} represents either group represented by the formulae (4); "p'" represents an integer of 0 to 5 and "q₁" represents an integer of 1 to 6, provided that p'+q₁ is an integer of 1 or more and 6 or less; and "q₂" represents 0 or 1.
[13]: A patterning process for forming a pattern in a substrate to be processed, comprising the steps of:
   (I-1) applying the composition for forming a metal-containing film of any one of the above [6] to [12] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask;
      and
   (I-5) processing the substrate to be processed while using the metal-containing film having the formed pattern as a mask to form the pattern in the substrate to be processed.
[14]: A patterning process for forming a pattern in a substrate to be processed, comprising the steps of:
   (II-1) applying the composition for forming a metal-containing film of any one of the above [6] to [12] onto a substrate to be processed, followed by heating to form a metal-containing film;
   (II-2) forming a silicon-containing resist middle layer film on the metal-containing film;
   (II-3) forming a resist upper layer film on the silicon-containing resist middle layer film by using a photoresist material;
   (II-4) subjecting the resist upper layer film to pattern exposure and then development with a developer to form a pattern in the resist upper layer film;
   (II-5) transferring the pattern to the silicon-containing resist middle layer film by dry etching while using the resist upper layer film having the formed pattern as a mask;
   (II-6) transferring the pattern to the metal-containing film by dry etching while using the silicon-containing resist middle layer film having the transferred pattern as a mask; and
   (II-7) processing the substrate to be processed while using the metal-containing film having the formed pattern as a mask to form the pattern in the substrate to be processed.
[15]: A patterning process for forming a pattern in a substrate to be processed, comprising the steps of:
   (III-1) applying the composition for forming a metal-containing film of any one of the above [6] to [12] onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[16]: The patterning process of the above [15], wherein the inorganic hard mask middle layer film is formed by a CVD method or an ALD method.
[17]: A patterning process for forming a pattern in a substrate to be processed, comprising the steps of:
   (IV-1) applying the composition for forming a metal-containing film of any one of the above [6] to [12] onto a substrate to be processed, followed by heating to form a metal-containing film;
   (IV-2) forming a resist underlayer film on the metal-containing film;
   (IV-3) forming a silicon-containing resist middle layer film or a combination of an inorganic hard mask middle layer film selected from a silicon oxide film, a silicon nitride film, and a silicon oxynitride film and an organic thin film on the resist underlayer film;
   (IV-4) forming a resist upper layer film on the silicon-containing resist middle layer film or the organic thin film by using a photoresist material;
   (IV-5) subjecting the resist upper layer film to pattern exposure and then development with a developer to form a pattern in the resist upper layer film;
   (IV-6) transferring the pattern to the silicon-containing resist middle layer film or the organic thin film and the inorganic hard mask middle layer film by dry etching while using the resist upper layer film having the formed pattern as a mask;
   (IV-7) transferring the pattern to the resist underlayer film by dry etching while using the silicon-containing resist middle layer film or the inorganic hard mask middle layer film having the transferred pattern as a mask;
   (IV-8) transferring the pattern to the metal-containing film by dry etching while using the resist underlayer film having the transferred pattern as a mask; and
   (IV-9) processing the substrate to be processed while using the metal-containing film having the formed pattern as a mask to form the pattern in the substrate to be processed.
[18]: A tone-reversal patterning process for forming a pattern in a substrate to be processed, comprising the steps of:
   (V-1) forming a resist underlayer film on a substrate to be processed;
   (V-2) forming a resist middle layer film or a combination of an inorganic hard mask middle layer film selected from a silicon oxide film, a silicon nitride film, and a silicon oxynitride film and an organic thin film on the resist underlayer film;
   (V-3) forming a resist upper layer film on the resist middle layer film or the combination of the inorganic hard mask middle layer film and the organic thin film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film of any one of the above [6] to [12] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.
The present invention also refers to the following numbered embodiments, wherein the term "claim" means embodiment:
1. A compound for forming a metal-containing film to be contained in a composition for forming a metal-containing film, wherein the compound is a metal compound comprising at least one kind of metal atom selected from the group consisting of Ti, Zr, and Hf and a ligand coordinated to the metal atom, and the ligand includes a crosslinking group represented by one of the following general formulae (W-1), 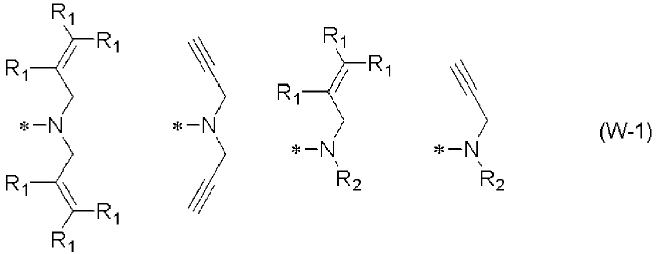 wherein R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.
2. The compound for forming a metal-containing film according to claim 1, wherein the compound is represented by the following general formula (A), 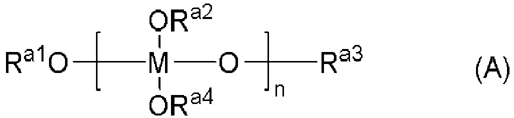 wherein M represents Ti, Zr, or Hf; R^{a1}, R^{a2}, R^{a3}, and R^{a4} each represent an organic group represented by the following general formula (1), a silicon-containing organic group represented by the following general formula (2), or an alkyl group having 1 to 10 carbon atoms, at least one of R^{a1}, R^{a2}, R^{a3}, and R^{a4} being an organic group represented by the following general formula (1) and at least one of R^{a1}, R^{a2}, R^{a3}, and R^{a4} being a silicon-containing organic group represented by the following general formula (2); and "n" represents 1 to 30, 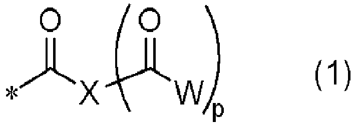 wherein X represents an organic group having 1 to 31 carbon atoms and having a valency of p+1; W represents any structure represented by one of the general formulae (W-1); "p" represents 1 to 4; and "*" represents an attachment point to an oxygen atom, 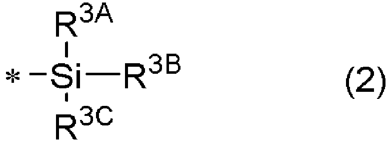 wherein R^{3A}, R^{3B}, and R^{3C} each represent any organic group selected from an organic group having 2 to 30 carbon atoms and having a crosslinking group of any structure represented by one of the following general formulae (c-1) to (c-3), a substituted or unsubstituted alkyl group having 1 to 20 carbon atoms, and an aryl group having 6 to 20 carbon atoms; and "*" represents an attachment point to an oxygen atom, 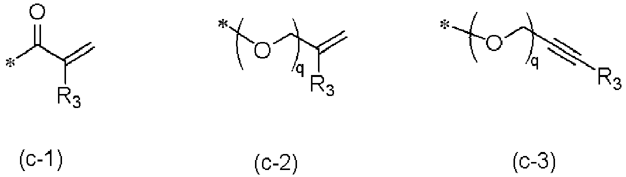 wherein R₃ represents a hydrogen atom or a monovalent organic group having 1 to 10 carbon atoms; "q" represents 0 or 1; and "*" represents an attachment point.
3. The compound for forming a metal-containing film according to claim 2, wherein the X in the general formula (1) represents a saturated hydrocarbon group having 1 to 20 carbon atoms or an unsaturated hydrocarbon group having 2 to 20 carbon atoms.
4. The compound for forming a metal-containing film according to claim 3, wherein the X in the general formula (1) represents one of the following general formulae (3), 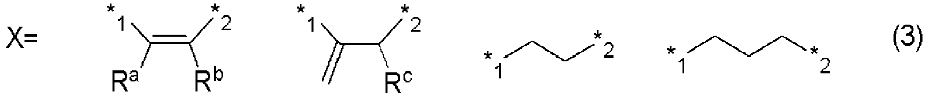 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.
5. The compound for forming a metal-containing film according to any one of claims 2 to 4, wherein the silicon-containing organic group has a structure represented by one of the following general formulae (2A), 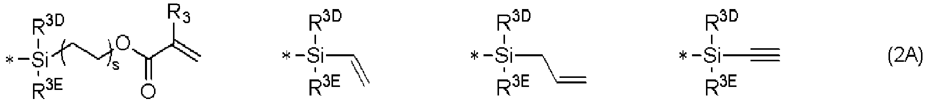 wherein R^{3D} and R^{3E} each represent an organic group selected from a substituted or unsubstituted alkyl group having 1 to 20 carbon atoms and an aryl group having 6 to 20 carbon atoms; R₃ is as defined above; "s" represents 1 to 10; and "*" represents an attachment point to an oxygen atom.
6. A composition for forming a metal-containing film comprising: (A) the compound for forming a metal-containing film according to any one of claims 1 to 5; and (B) an organic solvent.
7. The composition for forming a metal-containing film according to claim 6, further comprising one or more of (C) a crosslinking agent, (E) a surfactant, and (F) an acid generator.
8. The composition for forming a metal-containing film according to claim 6 or 7, wherein the organic solvent (B) contains, as (B1) a high-boiling-point solvent, one or more kinds of organic solvent having a boiling point of 180°C or higher.
9. The composition for forming a metal-containing film according to any one of claims 6 to 8, further comprising (G) metal oxide nanoparticles having an average primary particle size of 100 nm or less.
10. The composition for forming a metal-containing film according to claim 9, wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.
11. The composition for forming a metal-containing film according to any one of claims 6 to 10, further comprising (BP) a flowability accelerator having any organic group represented by the following general formulae (3') and an aromatic ring, 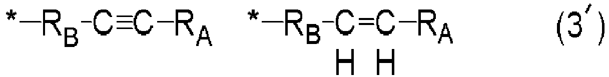 wherein "*" represents an attachment point to an oxygen atom; R_{B} represents a divalent organic group having 1 to 10 carbon atoms; and R_{A} represents a hydrogen atom or a monovalent organic group having 1 to 10 carbon atoms.
12. The composition for forming a metal-containing film according to claim 11, wherein the flowability accelerator (BP) has at least one constitutional unit represented by the following general formulae (BP-1), (BP-2), (BP-3), (BP-4), and (BP-5), 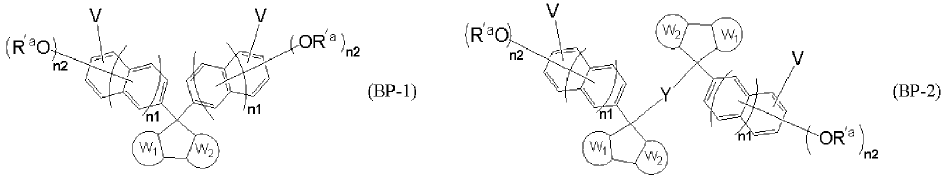 wherein W₁ and each independently represent a benzene ring or a naphthalene ring, part of hydrogen atoms in the benzene ring and the naphthalene ring optionally being substituted with a hydrocarbon group having 1 to 6 carbon atoms; each R'^{a} independently represents either group represented by the following formulae (4); Y represents any group represented by the following formulae (5); each "n₁" independently represents 0 or 1; each "n₂" independently represents 1 or 2; and each V independently represents a hydrogen atom or an attachment point, 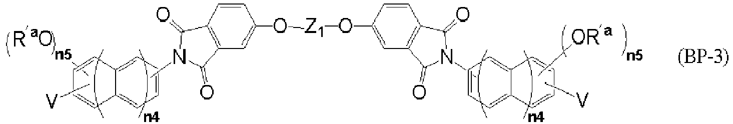 wherein Z₁ represents any group represented by the following general formulae (6); each R'^{a} independently represents either group represented by the following formulae (4); each "n₄" independently represents 0 or 1; each "n₅" independently represents 1 or 2; and each V independently represents a hydrogen atom or an attachment point, 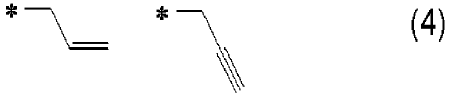 wherein "*" represents an attachment point to an oxygen atom, 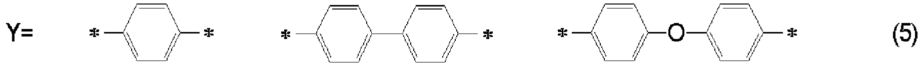 wherein "*" represents an attachment point, 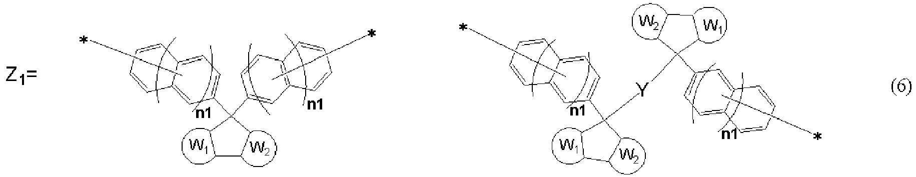 wherein W₁, W₂, Y, and "n₁" are as defined above; and "*" represents an attachment point, 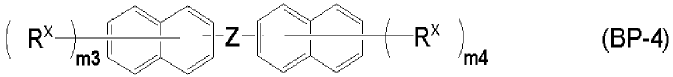 wherein "m₃" and "m₄" each independently represent 1 or 2; Z represents a single bond or any structure represented by the following general formulae (7); and each R^{x} independently represents any structure represented by the following general formulae (8), 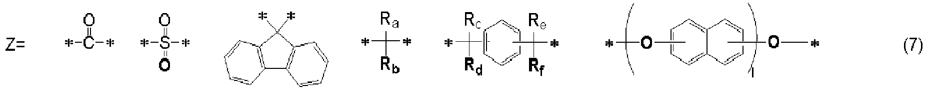 wherein "*" represents an attachment point; "l" represents an integer of 0 to 3; Rₐ to R_{f} each independently represent a hydrogen atom, an alkyl group having 1 to 10 carbon atoms and optionally having a substituent fluorine atom, a phenyl group, or a phenylethyl group, Rₐ and R_{b} optionally being bonded to each other to form a cyclic compound, 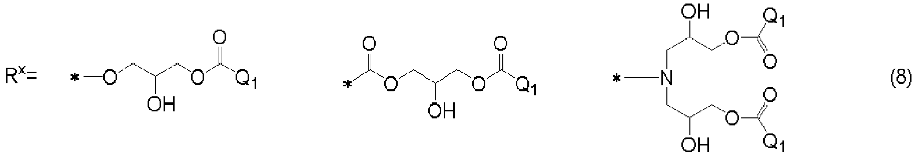 wherein "*" represents an attachment point to an aromatic ring; and Q₁ represents a linear saturated hydrocarbon group having 1 to 30 carbon atoms or a structure represented by the following general formula (9), 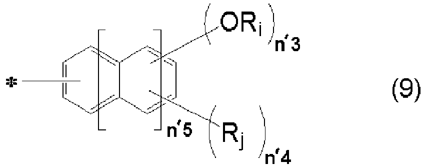 wherein "*" represents an attachment point to a carbonyl group; Rᵢ represents either group represented by the formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n'₃" and "n'₄" each represent a number of substituents on an aromatic ring, the number each representing an integer of 0 to 7, provided that n'₃+n'₄ is 0 or more and 7 or less; and "n'₅" represents 0 to 2, 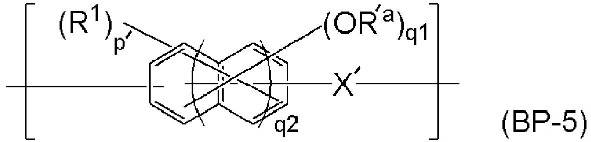 wherein R¹ represents a saturated monovalent organic group having 1 to 30 carbon atoms or an unsaturated monovalent organic group having 2 to 30 carbon atoms; X' represents a divalent organic group having 1 to 30 carbon atoms; R'^{a} represents either group represented by the formulae (4); "p'" represents an integer of 0 to 5 and "q₁" represents an integer of 1 to 6, provided that p'+q₁ is an integer of 1 or more and 6 or less; and "q₂" represents 0 or 1.
13. A patterning process for forming a pattern in a substrate to be processed, comprising the steps of:
   (I-1) applying the composition for forming a metal-containing film according to any one of claims 6 to 12 onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
14. A patterning process for forming a pattern in a substrate to be processed, comprising the steps of:
   (II-1) applying the composition for forming a metal-containing film according to any one of claims 6 to 12 onto a substrate to be processed, followed by heating to form a metal-containing film;
   (II-2) forming a silicon-containing resist middle layer film on the metal-containing film;
   (II-3) forming a resist upper layer film on the silicon-containing resist middle layer film by using a photoresist material;
   (II-4) subjecting the resist upper layer film to pattern exposure and then development with a developer to form a pattern in the resist upper layer film;
   (II-5) transferring the pattern to the silicon-containing resist middle layer film by dry etching while using the resist upper layer film having the formed pattern as a mask;
   (II-6) transferring the pattern to the metal-containing film by dry etching while using the silicon-containing resist middle layer film having the transferred pattern as a mask; and
   (II-7) processing the substrate to be processed while using the metal-containing film having the formed pattern as a mask to form the pattern in the substrate to be processed.
15. A patterning process for forming a pattern in a substrate to be processed, comprising the steps of:
   (III-1) applying the composition for forming a metal-containing film according to any one of claims 6 to 12 onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
16. The patterning process according to claim 15, wherein the inorganic hard mask middle layer film is formed by a CVD method or an ALD method.
17. A patterning process for forming a pattern in a substrate to be processed, comprising the steps of:
   (IV-1) applying the composition for forming a metal-containing film according to any one of claims 6 to 12 onto a substrate to be processed, followed by heating to form a metal-containing film;
   (IV-2) forming a resist underlayer film on the metal-containing film;
   (IV-3) forming a silicon-containing resist middle layer film or a combination of an inorganic hard mask middle layer film selected from a silicon oxide film, a silicon nitride film, and a silicon oxynitride film and an organic thin film on the resist underlayer film;
   (IV-4) forming a resist upper layer film on the silicon-containing resist middle layer film or the organic thin film by using a photoresist material;
   (IV-5) subjecting the resist upper layer film to pattern exposure and then development with a developer to form a pattern in the resist upper layer film;
   (IV-6) transferring the pattern to the silicon-containing resist middle layer film or the organic thin film and the inorganic hard mask middle layer film by dry etching while using the resist upper layer film having the formed pattern as a mask;
   (IV-7) transferring the pattern to the resist underlayer film by dry etching while using the silicon-containing resist middle layer film or the inorganic hard mask middle layer film having the transferred pattern as a mask;
   (IV-8) transferring the pattern to the metal-containing film by dry etching while using the resist underlayer film having the transferred pattern as a mask; and
   (IV-9) processing the substrate to be processed while using the metal-containing film having the formed pattern as a mask to form the pattern in the substrate to be processed.
18. A tone-reversal patterning process for forming a pattern in a substrate to be processed, comprising the steps of:
   (V-1) forming a resist underlayer film on a substrate to be processed;
   (V-2) forming a resist middle layer film or a combination of an inorganic hard mask middle layer film selected from a silicon oxide film, a silicon nitride film, and a silicon oxynitride film and an organic thin film on the resist underlayer film;
   (V-3) forming a resist upper layer film on the resist middle layer film or the combination of the inorganic hard mask middle layer film and the organic thin film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film according to any one of claims 6 to 12 onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.

## Claims

1. A compound for forming a metal-containing film to be contained in a composition for forming a metal-containing film, wherein the compound is a metal compound comprising at least one kind of metal atom selected from the group consisting of Ti, Zr, and Hf and a ligand coordinated to the metal atom, and the ligand includes a crosslinking group represented by one of the following general formulae (W-1), 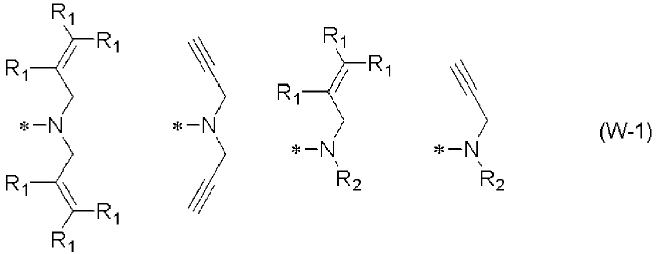 wherein R₁'s each represent a hydrogen atom or a methyl group and are identical to or different from each other; R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.

2. The compound for forming a metal-containing film according to claim 1, wherein the compound is represented by the following general formula (A), 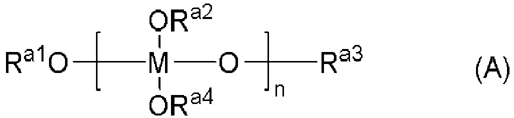 wherein M represents Ti, Zr, or Hf; R^{a1}, R^{a2}, R^{a3}, and R^{a4} each represent an organic group represented by the following general formula (1), a silicon-containing organic group represented by the following general formula (2), or an alkyl group having 1 to 10 carbon atoms, at least one of R^{a1}, R^{a2}, R^{a3}, and R^{a4} being an organic group represented by the following general formula (1) and at least one of R^{a1}, R^{a2}, R^{a3}, and R^{a4} being a silicon-containing organic group represented by the following general formula (2); and "n" represents 1 to 30, 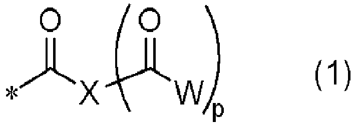 wherein X represents an organic group having 1 to 31 carbon atoms and having a valency of p+1; W represents any structure represented by one of the general formulae (W-1); "p" represents 1 to 4; and "*" represents an attachment point to an oxygen atom, 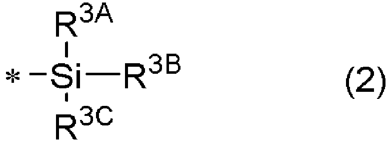 wherein R^{3A}, R^{3B}, and R^{3C} each represent any organic group selected from an organic group having 2 to 30 carbon atoms and having a crosslinking group of any structure represented by one of the following general formulae (c-1) to (c-3), a substituted or unsubstituted alkyl group having 1 to 20 carbon atoms, and an aryl group having 6 to 20 carbon atoms; and "*" represents an attachment point to an oxygen atom, 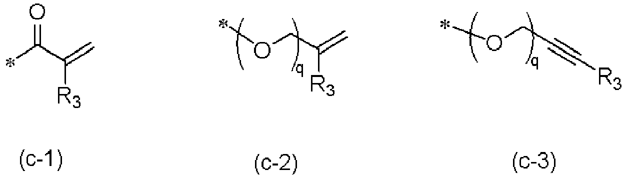 wherein R₃ represents a hydrogen atom or a monovalent organic group having 1 to 10 carbon atoms; "q" represents 0 or 1; and "*" represents an attachment point.

3. The compound for forming a metal-containing film according to claim 2, wherein the X in the general formula (1) represents a saturated hydrocarbon group having 1 to 20 carbon atoms or an unsaturated hydrocarbon group having 2 to 20 carbon atoms.

4. The compound for forming a metal-containing film according to claim 3, wherein the X in the general formula (1) represents one of the following general formulae (3), 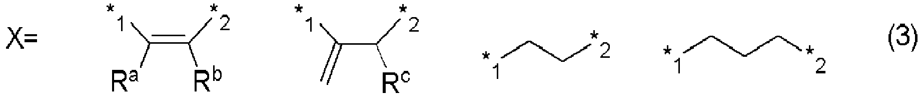 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.

5. The compound for forming a metal-containing film according to any one of claims 2 to 4, wherein the silicon-containing organic group has a structure represented by one of the following general formulae (2A), 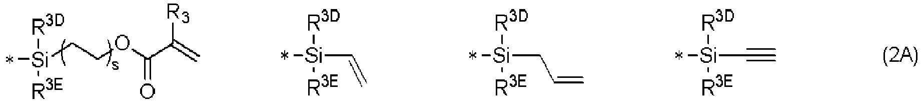 wherein R^{3D} and R^{3E} each represent an organic group selected from a substituted or unsubstituted alkyl group having 1 to 20 carbon atoms and an aryl group having 6 to 20 carbon atoms; R₃ is as defined above; "s" represents 1 to 10; and "*" represents an attachment point to an oxygen atom.

6. A composition for forming a metal-containing film comprising: (A) the compound for forming a metal-containing film according to any one of claims 1 to 5; and (B) an organic solvent.

7. The composition for forming a metal-containing film according to claim 6, further comprising one or more of (C) a crosslinking agent, (E) a surfactant, and (F) an acid generator.

8. The composition for forming a metal-containing film according to claim 6 or 7, wherein the organic solvent (B) contains, as (B1) a high-boiling-point solvent, one or more kinds of organic solvent having a boiling point of 180°C or higher.

9. The composition for forming a metal-containing film according to any one of claims 6 to 8, further comprising (G) metal oxide nanoparticles having an average primary particle size of 100 nm or less.

10. The composition for forming a metal-containing film according to claim 9, wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.

11. The composition for forming a metal-containing film according to any one of claims 6 to 10, further comprising (BP) a flowability accelerator having any organic group represented by the following general formulae (3') and an aromatic ring, 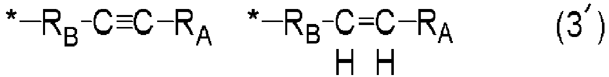 wherein "*" represents an attachment point to an oxygen atom; R_{B} represents a divalent organic group having 1 to 10 carbon atoms; and R_{A} represents a hydrogen atom or a monovalent organic group having 1 to 10 carbon atoms.

12. The composition for forming a metal-containing film according to claim 11, wherein the flowability accelerator (BP) has at least one constitutional unit represented by the following general formulae (BP-1), (BP-2), (BP-3), (BP-4), and (BP-5), 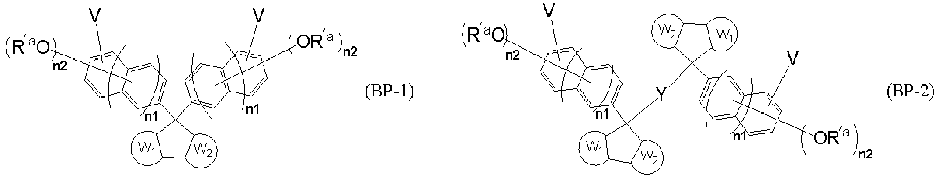 wherein W₁ and each independently represent a benzene ring or a naphthalene ring, part of hydrogen atoms in the benzene ring and the naphthalene ring optionally being substituted with a hydrocarbon group having 1 to 6 carbon atoms; each R'^{a} independently represents either group represented by the following formulae (4); Y represents any group represented by the following formulae (5); each "n₁" independently represents 0 or 1; each "n₂" independently represents 1 or 2; and each V independently represents a hydrogen atom or an attachment point, 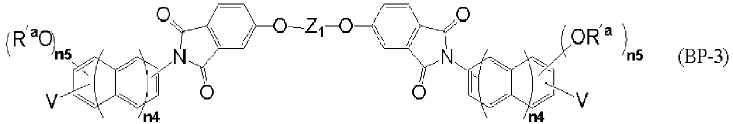 wherein Z₁ represents any group represented by the following general formulae (6); each R'^{a} independently represents either group represented by the following formulae (4); each "n₄" independently represents 0 or 1; each "n₅" independently represents 1 or 2; and each V independently represents a hydrogen atom or an attachment point, 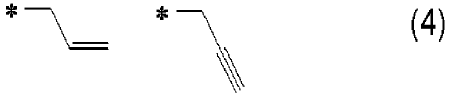 wherein "*" represents an attachment point to an oxygen atom, 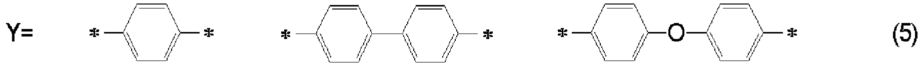 wherein "*" represents an attachment point, 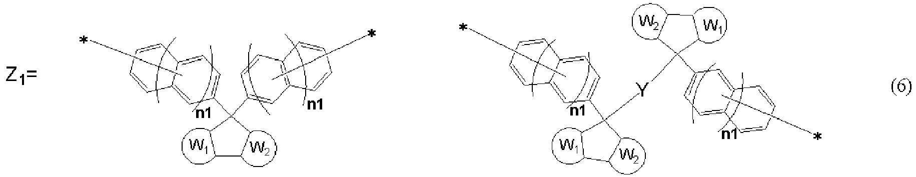 wherein W₁, W₂, Y, and "n₁" are as defined above; and "*" represents an attachment point, 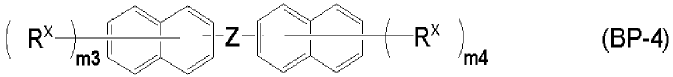 wherein "m₃" and "m₄" each independently represent 1 or 2; Z represents a single bond or any structure represented by the following general formulae (7); and each R^{x} independently represents any structure represented by the following general formulae (8), 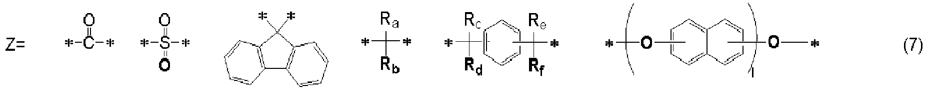 wherein "*" represents an attachment point; "l" represents an integer of 0 to 3; Rₐ to R_{f} each independently represent a hydrogen atom, an alkyl group having 1 to 10 carbon atoms and optionally having a substituent fluorine atom, a phenyl group, or a phenylethyl group, Rₐ and R_{b} optionally being bonded to each other to form a cyclic compound, 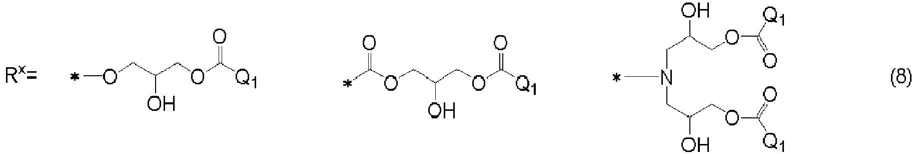 wherein "*" represents an attachment point to an aromatic ring; and Q₁ represents a linear saturated hydrocarbon group having 1 to 30 carbon atoms or a structure represented by the following general formula (9), 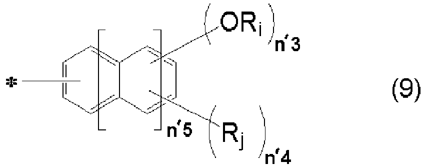 wherein "*" represents an attachment point to a carbonyl group; Rᵢ represents either group represented by the formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n'₃" and "n'₄" each represent a number of substituents on an aromatic ring, the number each representing an integer of 0 to 7, provided that n'₃+n'₄ is 0 or more and 7 or less; and "n'₅" represents 0 to 2, 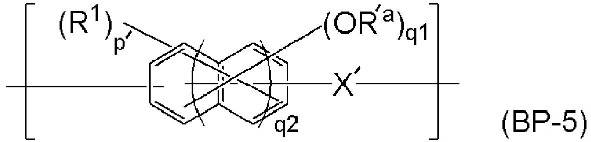 wherein R¹ represents a saturated monovalent organic group having 1 to 30 carbon atoms or an unsaturated monovalent organic group having 2 to 30 carbon atoms; X' represents a divalent organic group having 1 to 30 carbon atoms; R'^{a} represents either group represented by the formulae (4); "p'" represents an integer of 0 to 5 and "q₁" represents an integer of 1 to 6, provided that p'+q₁ is an integer of 1 or more and 6 or less; and "q₂" represents 0 or 1.

13. A patterning process for forming a pattern in a substrate to be processed, comprising the steps of:
A)
(I-1) applying the composition for forming a metal-containing film according to any one of claims 6 to 12 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed; or
B)
(II-1) applying the composition for forming a metal-containing film according to any one of claims 6 to 12 onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed; or
C)
(III-1) applying the composition for forming a metal-containing film according to any one of claims 6 to 12 onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed; or
D) (IV-1) applying the composition for forming a metal-containing film according to any one of claims 6 to 12 onto a substrate to be processed, followed by heating to form a metal-containing film;
(IV-2) forming a resist underlayer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the resist underlayer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the resist underlayer film by dry etching while using the silicon-containing resist middle layer film or the inorganic hard mask middle layer film having the transferred pattern as a mask;
(IV-8) transferring the pattern to the metal-containing film by dry etching while using the resist underlayer film having the transferred pattern as a mask; and
(IV-9) processing the substrate to be processed while using the metal-containing film having the formed pattern as a mask to form the pattern in the substrate to be processed.

14. The patterning process according to embodiment C) of claim 13, wherein the inorganic hard mask middle layer film is formed by a CVD method or an ALD method.

15. A tone-reversal patterning process for forming a pattern in a substrate to be processed, comprising the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 6 to 12 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.
